# EUROPEAN PATENT APPLICATION

(11) **EP 4 726 765 A1**
(43) Date of publication of application: **15.04.2026**
(21) Application number: 24205759.4
(22) Date of filing: 10.10.2024
(51) Int. Cl.: H01J 37/02, H01J 37/153, H01J 37/22, H01J 37/244, H01J 37/28

(54) **CHARGED PARTICLE ASSESSMENT SYSTEM AND METHOD**

(71) Applicant: ASML Netherlands B.V., 5500 AH Veldhoven (NL)
(72) Inventor: DE LEON ARIZPE, Israel, 5500 AH Veldhoven (NL); MANGNUS, Albertus Victor Gerardus, 5500 AH Veldhoven (NL); SAHIN, Ezgi, 5500 AH Veldhoven (NL); LÖW, Peter, 5500 AH Veldhoven (NL); WIELAND, Marco Jan-Jaco, 5500 AH Veldhoven (NL); VAN T WESTEINDE, Maaike, 5500 AH Veldhoven (NL)
(74) Representative: ASML Netherlands B.V.

(57) **Abstract**

A charged particle assessment system comprising a sample holder configured to hold a sample having a surface; a charged particle-optical device configured to project a charged particle beam towards the sample, the charged particle-optical device being configured to deflect the charged particle beam over a part of the surface of the sample, the charged particle-optical device having a device surface, the device surface facing, in use, the surface of the sample; a projection assembly arranged to direct a plurality of light beams along respective light paths, wherein the plurality of light beams include light beams having different wavelengths; and wherein the device surface comprises a plurality of redirecting elements, each of the redirecting elements being associated with one of the respective wavelengths, wherein each of the redirecting elements is configured to direct light onto the sample.

## Description

### FIELD

The present invention relates to charged particle assessment systems, charged particle-optical elements, and methods of operating charged particle assessment systems.

### BACKGROUND

During manufacturing processes of, for example, semiconductor integrated circuit (IC) chips or displays, undesired defects may occur on a substrate (e.g. wafer) or a mask. Such defects may reduce yield. Defects may occur as a consequence of all kinds of processing necessary to produce an integrated circuit or display, for example, lithography, etching, deposition or chemical mechanical polishing. Defects may include patterning defects, in which the created pattern lies outside the pattern tolerance for the process, and particles. Monitoring the extent of defects during the manufacturing processes is therefore important. Such monitoring (or more generally assessment) includes the determination of the existence of a defect, but also the classification of the types of defects found.

For the assessment of a sample, different types of inspection or metrology systems have been used, including charged particle systems such as electron microscopes. Such assessment for inspection may relates to defects, for example the existence and classification of such defects. Electron microscopes typically generate a probe beam (also often referred to as primary beam) which may, for example, be scanned across a part of the substrate (such as in a scanning electron microscopes (SEM)). Collecting interaction products that result from the interaction of the primary beam with the part of the substrate, allows the electron microscope to collect data representing the probed part of the substrate. The data may be processed/rendered for example by the electron microscope to generate an image representation of the part of the substrate. The collected data for example as a generated image representation allows for measuring structures on the part of the substrate, or allows for identifying defective structures by comparing the image representation with a reference. Such measurement may be referred to as metrology; such defect inspection may be referred to as inspection. The interaction products may contain charged particles which may be referred to as signal particles (e.g. signal electrons), such as secondary electrons and backscattered electrons, and may contain other interaction products, such as X-ray radiation.

When the primary electron beam scans the sample, charges may accumulate on the sample due to the beam current, which may affect the quality of the image. To regulate the accumulated charges on the sample, an Advanced Charge Controller (ACC) module may be employed to direct a light beam, such as a laser beam, on the sample, so as to control the accumulated charges due to effects such as photoconductivity, photoelectric, or thermal effects. It can be difficult to direct the light beam on the sample. For example, the dimensions of the pattern inspection tool may make it difficult to reach the sample with the light beam.

WO2022228943 describes a charged particle assessment system configured to illuminate a sample with a light beam for an ACC module. The charged particle assessment system of WO2022228943 comprises a charged particle-optical device configured to project a charged particle beam towards a portion of the surface of the sample, the charged particle-optical device having a facing surface facing the sample holder; and a projection assembly arranged to direct a light beam along a light path such that the light beam reflects at least twice off the facing surface before being incident on the portion of the surface of the sample.

### SUMMARY

It is an object of the present disclosure to provide embodiments that support illuminating the sample with a light beam for an ACC module with improved efficiency.

According to a first aspect of the invention there is provided a charged particle assessment system comprising: a sample holder configured to hold a sample having a surface; a charged particle-optical device configured to project a charged particle beam towards the sample, the charged particle-optical device being configured to deflect the charged particle beam over a part of the surface of the sample, the charged particle-optical device having a device surface, the device surface facing, in use, the surface of the sample; a projection assembly arranged to direct a plurality of light beams along respective light paths, wherein the plurality of light beams include light beams having different wavelengths; and wherein the device surface comprises a plurality of redirecting elements, each of the redirecting elements being associated with one of the respective wavelengths, wherein each of the redirecting elements is configured to direct light onto the sample.

According to a second aspect of the present invention, there is provided a method of operating a charged particle system comprising: projecting a charged particle beam towards a sample using a charged particle-optical device, the charged particle-optical device being configured to deflect the charged particle beam over a part of the surface of the sample, the charged particle-optical device having a device surface, the device surface facing, in use, the surface of the sample ; directing a plurality of light beams along respective light paths, wherein the plurality of light beams includes light beams having respective wavelengths that are different from each other, wherein the device surface comprises a plurality of redirecting elements, each of the redirecting elements being associated with one of the respective wavelengths, wherein each of the redirecting elements is configured to direct light onto the sample.

According to a third aspect of the present invention, there is provided a charged particle-optical element comprising a detector for detecting interaction products from interaction of a charged particle beam with a sample, the detector having a device surface configured to face, in use, a sample, wherein the device surface comprises a plurality of redirecting elements, each of the redirecting elements being associated with one respective central wavelength, wherein each of the redirecting elements is configured to direct light onto the sample.

### BRIEF DESCRIPTION OF THE DRAWINGS

Embodiments of the invention will now be described, by way of example only, with reference to the accompanying schematic drawings, in which:
- Figure 1 is a schematic diagram of an exemplary assessment apparatus;
- Figure 2 schematically depicts a multi-beam charged particle-optical device, for example of the assessment apparatus of Figure 1;
- Figure 3 schematically depicts a multi-beam charged particle-optical device, for example of the assessment apparatus of Figure 1;
- Figure 4 schematically depicts an alternative multi-beam charged particle-optical device, for example of the assessment apparatus of Figure 1;
- Figure 5 schematically depicts a charged particle-optical device array;
- Figure 6 schematically depicts an alternative multi-beam charged particle-optical device, for example of the assessment apparatus of Figure 1;
- Figure 7 schematically depicts a single beam charged particle-optical device, for example of the assessment apparatus of Figure 1;
- Figure 8 schematically depicts an alternative multi-beam charged particle-optical device, for example of the assessment apparatus of Figure 1;
- Figure 9 schematically depicts part of the multi-beam charged particle-optical device of Figure 8;
- Figure 10 schematically depicts a detector array in plan view;
- Figure 11 schematically depicts a detector element in cross-section;
- Figure 12 is a schematic cross-sectional view of an objective lens array of a charged particle assessment system according to an embodiment;
- Figure 13 is a bottom view of a detector element of a detector;
- Figure 14 is a schematic diagram of a light beam entering between the electron-optical device and the sample according to an embodiment;
- Figure 15 is a diagram explaining the focus angle of a light beam entering between the electron-optical device and the sample according to an embodiment;
- Figure 16 is a schematic diagram of a projection assembly projecting a light beam entering between the electron-optical device and the sample according to an embodiment;
- Figure 17 is a schematic diagram of a light beam entering between the electron-optical device and the sample according to an embodiment.
- Figure 18 is shows the diffraction efficiency of a commercially-available blazed diffraction grating as a function of wavelength;
- Figure 19 is a schematic representation of typical chromatic dispersion of a diffractive element showing the diffraction angle (θᵣ) for various optical wavelengths;
- Figure 20 is a schematic of a device surface of a charged particle-optical device;
- Figure 21 is a schematic of a cross-section of the charged particle-optical device taken along part of line A-A' of Figure 20;
- Figure 22 is a schematic of an example of a redirecting element of the present invention.
- Figure 23 schematically depicts part of the multi-beam charged particle-optical device, consistent with embodiments of the present invention.
- Figure 24 schematically depicts an example configuration of a detector array comprising redirecting elements disposed on the surface thereof;
- Figure 25 shows the electric field distribution in the space between a detector surface and the sample for various degrees of light coherence.

The Figures are schematic. Within the following description of drawings, the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons, and items referred to with reference to electrons, throughout the present document may therefore be more generally be considered to be references to charged particles, and items referred to in reference to charged particles, with the charged particles not necessarily being electrons. For example, references to an electron-optical device may more generally be considered to be references to a charged particle-optical device

### DETAILED DESCRIPTION

There is a trend in the semiconductor industry (often known as "Moore's law") to reduce the physical dimensions of structures representing circuit components on a substrate and/or to increase the packing density of such structures, in order to reduce the physical size of electronic devices and/or enhance the computing power of electronic devices. The physical dimensions of such structures may be reduced and/or the packing density of such structures may be increased by increasing lithographic resolution. Manufacturing processes of semiconductor IC chips can have 100s of individual steps. An error in any step of the manufacturing process has the potential to adversely affect the functioning of the electronic device. It is desirable to improve the overall yield of the manufacturing process. For example, to obtain a 75% yield for a 50-step manufacturing process (where a step may indicate the number of layers formed on a substrate), each individual step must have a yield greater than 99.4%. If an individual step has a yield of 95%, the overall yield of the manufacturing process would be as low as 7-8%. It is desirable to determine defects quickly so as to maintain a high substrate throughput, defined as the number of substrates processed per hour.

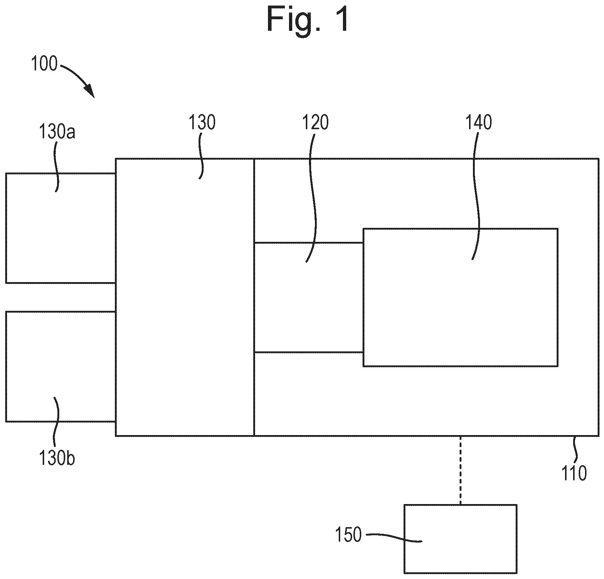

Figure 1 is a schematic diagram illustrating an exemplary assessment apparatus 100, e.g. a metrology apparatus or an inspection apparatus. The assessment apparatus 100 may be configured to scan a sample with one or more beams of electrons. The sample may be a semiconductor substrate, a substrate made of other material, or a mask, for example. The electrons interact with the sample and generate interaction products. The interaction products comprise signal electrons, e.g. secondary electrons and/or backscattered electrons, and possibly X-ray radiation. The assessment apparatus 100 may be configured to detect the interaction products from the sample so that a data set may be generated which may be processable into an image or any other data representation of the scanned area of the sample can be generated. For clarity, the description below focuses on embodiments in which the interaction products that are detected are signal electrons. The assessment apparatus 100 may comprise, for example during operation, a single beam or a plurality of beams, i.e. a multi-beam. The component beams of a multi-beam may be referred to as sub-beams or beamlets. A multi-beam may be used to scan different parts of a sample simultaneously. When the assessment apparatus 100 uses a multi-beam, the assessment apparatus 100 may assess a sample more quickly than when the assessment apparatus 100 uses a single-beam. For example, a high throughput of sample assessment may be achieved using a multibeam assessment apparatus than a single beam apparatus.

The assessment apparatus 100 of Figure 1 comprises a vacuum chamber 110, a load lock chamber 120, an electron-optical apparatus 140, an equipment front end module (EFEM) 130 and a controller 150. The electron-optical apparatus 140 (also known as an electron beam apparatus or an electron apparatus) may be within the vacuum chamber 110. The electron-optical apparatus 140 may comprise an electron-optical device (described in more detail below) and an actuatable stage. It should be appreciated that reference in the description to the electron-optical elements of the electron-optical apparatus 140 can be considered to be a reference to the electron-optical device.

The EFEM 130 includes a first loading port 130a and a second loading port 130b. The EFEM 130 may include additional loading port(s). The first loading port 130a and the second loading port 130b may, for example, receive substrate front opening unified pods that contain samples. One or more robot arms (not shown) in the EFEM 130 transport the samples to the load lock chamber 120.

The load lock chamber 120 is used to remove the gas around a sample. The load lock chamber 120 may be connected to a load lock vacuum pump system (not shown), which removes gas particles in the load lock chamber 120. The operation of the load lock vacuum pump system enables the load lock chamber to reach a first pressure below the atmospheric pressure. The vacuum chamber 110, which may be a main chamber of the assessment apparatus 100, is connected to a main chamber vacuum pump system (not shown). The main chamber vacuum pump system removes gas molecules from the vacuum chamber 110 so that the pressure around the sample reaches a second pressure equal to or lower than the first pressure. Different parts of the electron-optical apparatus 140 may have different levels of pressure below the atmospheric pressure. After reaching the required pressure, the sample leaves the load lock chamber 120 and is transported to the electron-optical apparatus 140 by which it may be assessed. The electron-optical apparatus 140 may use either a single beam or a multi-beam for the assessment. Alternatively, an electron-optical device array comprising a plurality of electron-optical devices may be used, further also referred to as a multi-column electron-array, in which each electron-optical device (or each column in the multi-column array) comprises, for example during operation, either a single beam or a multi-beam.

The controller 150 is electronically connected to the electron-optical apparatus 140. The controller 150 may be a processor (such as a computer) configured to control the assessment apparatus 100. The controller 150 may also include processing circuitry configured to execute data, signal and image processing functions for example on the data set e.g. embodied as signals such as detection signals. The controller 150 may thus include processing circuitry configured to execute processing functions on signal, image and other data produced in the assessment apparatus 100. While the controller 150 is shown in Figure 1 as being outside of the structure that includes the vacuum chamber 110, the load lock chamber 120, and the EFEM 130, it is appreciated that the controller 150 may be part of the structure. The controller 150 may be located in one of the components of the assessment apparatus 100 or it may be distributed over at least two of the components.

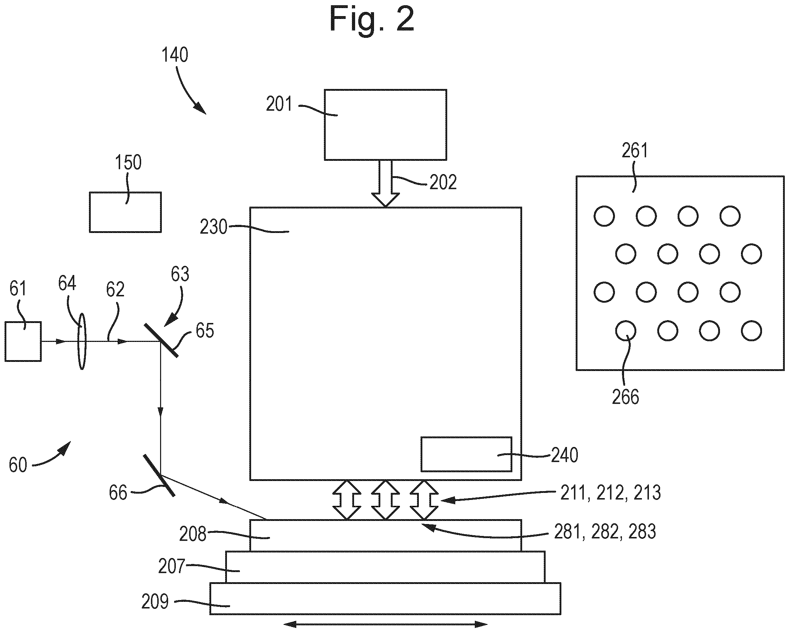

Figure 2 is a schematic diagram illustrating an exemplary electron-optical apparatus 140 which comprises a projection assembly 60. The electron-optical apparatus 140 may be provided as part of the assessment apparatus 100 of FIG. 1. The electron-optical apparatus 140 includes a source 201 and an electron-optical device 230 (which may also be referred to as an electron-optical column). The source 201 may comprise a cathode (not shown) and an extractor and/or anode (not shown). During operation, the source 201 is configured to emit electrons from the cathode. The electrons may be extracted or accelerated by the extractor and/or the anode to form the source beam 202.

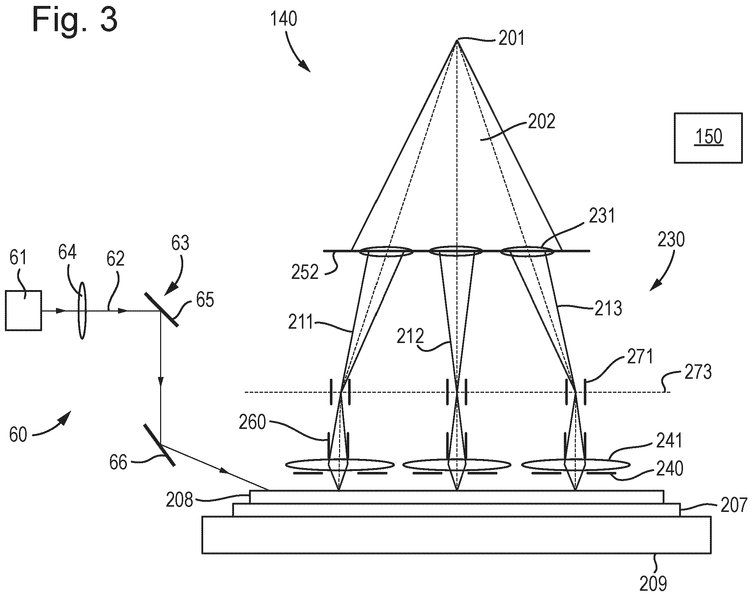

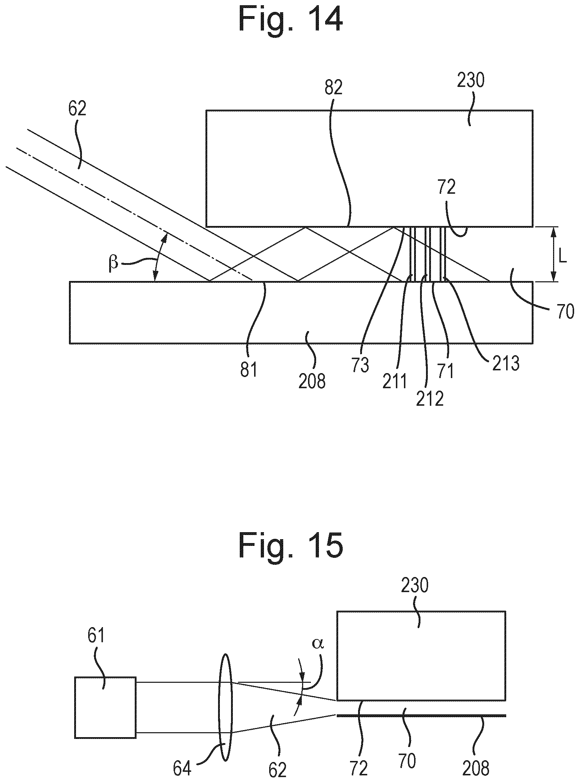

The projection assembly 60 may be a module and may be referred to as an ACC module. The projection assembly 60 is arranged to direct a light beam 62 such that the light beam 62 enters between the electron-optical device 230 and the sample 208. When the electron beam scans the sample 208, charges may be accumulated on the sample 208 due to large beam current, which may affect the quality of the image. To regulate the accumulated charges on the sample, the projection assembly 60 may be employed to illuminate the light beam 62 on the sample 208, so as to control the accumulated charges due to effects such as photoconductivity, photoelectric, or thermal effects. The projection assembly may be used in various configurations of an electron-optical apparatus 140, such as those shown in FIGs. 3, 4 and 8, as well as other configurations of an electron-optical apparatus 140. The projection assembly 60 will be described in more detail below with reference to FIG. 14, FIG. 15 and FIG. 16.

The electron-optical device 230 may be configured to convert the source beam 202 into a plurality of primary beams 211, 212, 213 (which may be referred to as sub-beams or beamlets). The electron-optical device 230 may be configured to direct the primary beams 211, 212, 213 along respective beam paths toward a sample location for the sample 208. Although three beams are illustrated, the number of beams may be of the order of 100s or 1,000s, for example up to 20,000 per electron-optical apparatus 140. The plurality of beams may be referred to collectively as a multi-beam or a beam grid. The different beams may be arranged relative to each other across the beam grid in a pattern. The pattern of the beam grid may be referred to array. The electron-optical device 230 has a field of view which may be defined as the area of the surface of the sample 208 within which the primary beams 211, 212, 213 can scan while the aberrations of the electron-optical device 230 remain within a defined value. Alternatively, the field of view may be defined by the maximum scan range of the electron-optical device 230. The field of view may be of the order of millimeters, for example up to 20mm at the sample 208.

The electron-optical device 230 comprises a plurality of electron-optical elements positioned along the beam paths. The electron-optical elements are configured to manipulate the beams. For example, the electron-optical elements may be configured to lens, focus, deflect or correct the beams. The electron-optical elements may be arranged in at least one stack of electron-optical elements. Such an electron-optical element may be positioned upbeam or downbeam with respect to another of the electron-optical elements. The terms upbeam and downbeam relate to the direction of the beams from the source 201 to the sample 208 during use of the electron-optical device 230, which may be expressed as a direction along one or more of the beam paths. In an embodiment some of the different electron-optical elements may take a planar form, such as a plate 261. An electric field that manipulates the beams may be generated between two plates 261, e.g. by applying, in use, different potentials to neighboring/adjoining plates 261 such as along the beam path. An electric field that manipulates the beams may be generated between surfaces of plates 261 across the beam path for example between the neighboring plates 261. One or more beam apertures 266 may be defined in the plates 261 for the passage of one or more beams. The beam apertures 266 may be arranged in a pattern such as a regular grid e.g. hexagonal or square. Such a pattern of the beam apertures 266 may be referred to as an aperture array (i.e. a two-dimensional array over the surface of the plate). The pattern of the beam apertures 266 may correspond to the pattern of beams within the beam grid. Beam apertures 266 in different plates operating on the same beam(s) are typically aligned.

The electron-optical elements may comprise one or more corrector arrays. For example, a corrector array may be integrated into the shape, position and/or size of the beam apertures 266 of the plates 261. The disclosure of such a corrector array as described in WO 2022101072 A1 is hereby incorporated by reference. One or more corrector arrays may comprise multipole deflectors with a specific superposition of potentials applied across the individually controllable electrodes. The disclosure in WO2012165955 of an array of multipole deflectors is hereby incorporated by reference.

One or more of the electron-optical elements may comprise an aperture for the path of a plurality of the beams. For example, the aperture may be a macro aperture for all of the beams. The disclosures of a slit aperture for a collimator or corrector comprising strip electrodes in WO 2021156121 A1 and WO 2021204734 A1 are hereby incorporated by reference. One or more electron-optical elements may comprise one or more plate electrodes that are curved across the path of the beam grid for use as a lens array, a corrector array and/or a collimator array such as disclosed in European patent application 23211553.5 filed 22 November 2023, which is hereby incorporated by reference at least so far as the use and application of curved plate electrodes.

In the current embodiment, the electron-optical device 230 may form three probe spots 281, 282, 283 on the surface of the sample 208. The electron-optical device 230 may be configured to deflect the primary beams 211, 212, 213 so as to scan the probe spots 281, 282, 283 across individual scanning areas of the sample 208. In response to incidence of the primary beams 211, 212, 213 on the sample 208, signal electrons are generated from the sample 208 which may include secondary electrons and backscattered electrons. Secondary electrons typically have electron energy of at most 50 eV. Backscattered electrons typically have electron energy of more than 50 eV and less than the landing energy of the primary beams 211, 212, 213.

The electron-optical apparatus 140 comprises a sample holder 207 that supports a sample 208. The sample holder 207 supports the sample 208 for assessment. The sample holder 207 is supported by an actuatable stage 209. The electron-optical apparatus 140 further comprises a detector array 240. The detector array 240 may be part of the electron-optical device 230. The detector array 240 e.g. detects signal electrons from the sample 208. The detector array 240 generates detection signals based on detection of the signal electrons.

In an embodiment, the detector array 240 may define the surface of the electron-optical apparatus 140 facing the sample 208, e.g. the bottom surface of the electron-optical device 230. There may be more than one detector array at different positions along the paths of the primary beams 211, 212, 213.

The detector array 240 may comprise a plurality of detector elements, with at least one detector element per beam. The detector elements may, for example, be charge capture electrodes, for example metal plates, which may be configured to detect at least some of the signal electrons. Alternatively or additionally, the detector elements may comprise detection diodes configured to detect at least some of the signal electrons. Alternatively or additionally, the detector elements may comprise a scintillator material (such as YAG) configured to convert signal electrons into photons that may be subsequently detected. The detector elements may be arranged around beam apertures 266 in the bottom surface of the electron-optical device 230 to allow the primary beams 211, 212, 213 to pass towards the sample 208. Each detector element may comprise a plurality of detection segments or may constitute a single sensitive surface for each beam. The detection signal generated by a detector element may be transmitted to a processor for generation of an image. For example, the detection signal may represent a grey value or an intensity value of a pixel of an image.

The detector array 240 may send the detection signals, for example as an imaging signal or a detection signal, to the controller 150 or to a signal processing system (not shown) which may be part of the controller 150. The controller 150 or the signal processing system may be configured to generate images of the corresponding scanned areas of the sample 208. The detector array 240 may be incorporated at least partly into the electron-optical device 230. Alternatively, the detector array 240 may be separate from the electron-optical device 230. For example, the electron-optical apparatus 140 may comprise a secondary electron-optical device configured to direct secondary electrons to the detector array 240. In such an embodiment, the secondary electron-optical device comprises a beam separator (such as a Wien filter, not shown). The beam separator may separate the paths of the primary electrons towards the sample 208 from the paths of the signal electrons away from the sample 208. Note, such a beam separator may be present in a different embodiment with a detector array within the electron-optical device 230 for directing the primary electrons towards the sample and the signal particles to detector elements of the detector array.

The controller 150 (for example a control system comprising distributed controllers) may be connected to various parts (e.g. components) of the electron-optical apparatus 140 of Figure 2, such as the source 201, the detector array 240, the electron-optical device 230, and the actuatable stage 209. The controller 150 may perform various image processing functions and signal processing functions. The controller 150 may also generate various control signals to govern operations of the assessment apparatus 100.

Figure 3 schematically depicts an electron-optical apparatus 140 of an assessment apparatus, e.g. the assessment apparatus 100 of Figure 1. The electron-optical apparatus 140 of Figure 3 may be the electron-optical apparatus 140 of Figure 2 in which the electron-optical elements of the electron-optical device 230 comprise a beam limiting aperture array 252, a condenser lens array 231, a collimator array 271 for example at an intermediate focus plane 273, a scan deflector array 260, an objective lens array 241 and the detector array 240.

The source 201 generates a diverging source beam 202. The beam limiting aperture array 252 defines a plurality of primary beams 211, 212, 213 from the source beam 202. The condenser lens array 231 focuses the primary beams 211, 212, 213 at the intermediate focus plane 273. The condenser lens array 231 may comprise the beam limiting aperture array 252. Alternatively, the condenser lens array 231 may be downbeam or upbeam of the beam limiting aperture array 252. The condenser lens array 231 may be electrostatic. In an alternative embodiment the condenser lens array 231 comprises a magnetic element for example as a plurality of magnetic elements / one or more magnetic elements.

The collimator array 271 is configured to collimate the primary beams 211, 212, 213 along respective beam paths towards and substantially orthogonal to a surface of the sample 208. The collimator array 271 may be located at or near the intermediate focus plane 273. The collimator array 271 may comprise a plurality of deflectors configured to deflect respective primary beams 211, 212, 213. Additionally or alternatively the collimator array 271 may comprise a lens or lens array that operates on the different beams to deflect the relative paths of the beams. The collimator array 271 may be electrostatic. The collimator array 271 may consist of a single plate 261 comprising electrodes around the beam apertures 266, such as on the surface around the beam apertures 266 and/or on the inside of the beam apertures 266. The electrodes may cooperate as a deflector per beam aperture 266. Alternatively, the collimator array 271 may comprise a stack of plates 261. In use a potential difference is applied between the plates 261 so as to generate a lensing effect at the beam apertures 266. The plates 261 may have a curvature across the beam path. Alternatively, the collimator array 271 may comprise a plurality of layers of strip electrode deflectors as shown in WO2021156121 and WO2021204734. A layer of strip electrode deflectors may consist of a plate. Although not shown in Figure 3, in an alternative embodiment the collimator array 271 is replaced by a macro collimator configured to collimate the primary beams 211, 212, 213. The macro collimator may be a magnetic lens, or an electrostatic lens, or a combination of magnetic and electrostatic lens. In a further alternative embodiment, the electron-optical device 230 comprises a macro collimator in addition to the collimator array 271.

The deflectors of the scan deflector array 260 may be formed at apertures of the scan deflector array 260. The deflectors may comprise respective sets of individually controllable electrodes. Such a deflector may be referred to as a multipole deflector. The individually controllable electrodes extend partially along the beam path of the respective beam. The individually controllable electrodes may be controlled to generate, in use, a scan movement of the respective beam across the sample 208. Typically, the sets of individually controllable electrodes operate to scan all of the primary beams 211, 212, 213 simultaneously in parallel across the individual fields of view of the respective objective lenses of the objective lens array 241. Alternatively, the scan deflector array 260 may comprise strip deflectors (as shown in WO2004081910, WO2021156121 and WO2021204734) configured to deflect a row of beams along the individual fields of view of the respective objective lenses of the objective lens array 241.

The objective lens array 241 is configured to focus the primary beams 211, 212, 213 onto the sample 208. The objective lens array 241 may comprise a stack of plates 261. Different potentials are applied to respective plates 261 so as to generate electrostatic fields between adjacent plates 261. The electrostatic fields generate electrostatic lenses that may be configured to focus the primary beams 211, 212, 213. The objective lens array 241 may be proximate the sample 208.

The stack of plates 261 of the objective lens array 241 may be referred to as, or as part of, an objective lens assembly. The objective lens assembly may comprise one or more of the scan deflector array 260, a corrector array (not shown) and the detector array 240 in addition to the objective lens array 241. The objective lens assembly may comprise additional plates having lens functionality providing additional degrees of electron-optical freedom. A control lens array may be comprised by such an additional plate.

In an embodiment the detector array 240 may be integrated into the objective lens array 241. Alternatively (or additionally) the detector array 240 may be upbeam of the bottom surface of the electron-optical device 230. For example, the detector array 240 may be within the objective lens assembly or even upbeam of the objective lens assembly. For example, the detector array 240 may be in or upbeam of the objective lens array 241.

The disclosures in EP 3869535 A1 and WO 2021165136 A1 of a source, a condenser lens array, a collimator array, an objective lens array and a detector array are hereby incorporated by reference.

The electron-optical device 230 may comprise one or more corrector arrays configured to at least partly correct one or more types of aberration of the beams. Such corrector arrays may be associated with or integrated into the condenser lens array 231, the collimator array 271 and/or the objective lens array 241, or between two of these arrays, e.g. between the condenser lens array and the collimator array.

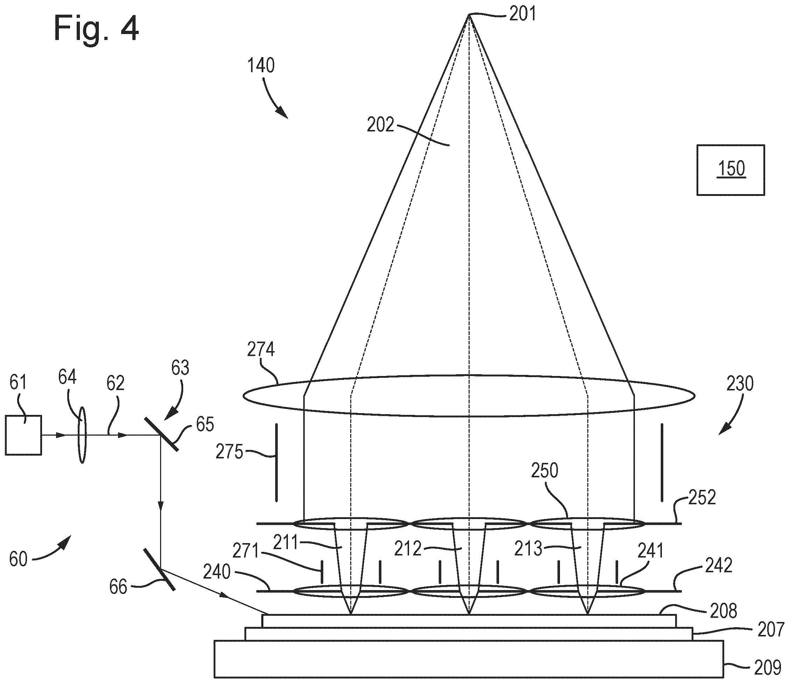

Figure 4 schematically depicts an electron-optical apparatus 140 of an assessment apparatus, e.g. the assessment apparatus 100 of Figure 1. The electron-optical apparatus 140 of Figure 4 may be the electron-optical apparatus 140 of Figure 2 in which the electron-optical device 230 comprises a macro condenser lens 274, a macro scan deflector 275, a beam limiting aperture array 252 (which may be referred to as an upper beam limiter), a control lens array 250, a collimator array 271, an objective lens array 241, a beam shaper array 242 (which may be referred to as a lower beam limiter) and the detector array 240.

The source 201 generates a diverging source beam 202. The macro condenser lens 274 is located between the source 201 and the objective lens array 241. The macro condenser lens 274 is configured to at least partly collimate the source beam 202. The macro scan deflector 275 is located between the macro condenser lens 274 and the objective lens array 241. The macro scan deflector 275 is configured to operate on the source beam 202 so that the primary beams 211, 212, 213 scan the surface of the sample 208. Additionally or alternatively the electron-optical device 230 may comprise a scan deflector array (not shown) downbeam of the control lens array 250. The macro condenser lens 274 and/or the macro scan deflector 275 may at least in part be magnetic.

The beam limiting aperture array 252 defines a plurality of primary beams 211, 212, 213 from the source beam 202. The beam shaper array 242 and the beam limiting aperture array 252 are plates 261 in which the beam apertures 266 are smaller in dimension than other plates of the electron-optical device 230. The beam apertures 266 of the beam limiting aperture array 252 define the primary beams 211, 212, 213. The beam apertures 266 of the beam shaper array 242 shape the primary beams 211, 212, 213 to at least partially correct for types of aberration in the beams.

The collimator array 271 is configured to collimate the primary beams 211, 212, 213 along respective beam paths towards and substantially orthogonal to a surface of the sample 208. The collimator array 271 may be located between the beam limiting aperture array 252 and the objective lens array 241. The collimator array 271 may be omitted. Alternatively, when the collimator array 271 is provided, then the macro condenser lens 274 may be omitted. The collimator array 271 may comprise a plurality of deflectors configured to deflect respective primary beams 211, 212, 213. The collimator array 271 may be electrostatic. The collimator array 271 may consist of a single plate 261 comprising the deflectors around the beam apertures 266, for example on the surface around the beam apertures 266 and/or on the inside of the beam apertures 266. Alternatively, the collimator array 271 may comprise a stack of plates 261. In use a potential difference is applied between the plates 261 so as to generate a lensing effect at the beam apertures 266. One or more of the plates may be curved across the path of the beam grid. Alternatively or additionally, the collimator array 271 may comprise a plurality of layers of strip electrode deflectors. A layer of strip electrode deflectors may be a plate.

The objective lens array 241 is configured to focus the primary beams 211, 212, 213 onto the sample 208. The objective lens array 241 may comprise a stack of plates 261. In use, different potentials may be applied to respective plates 261 so as to generate electrostatic fields between adjacent plates 261. The electrostatic fields generate electrostatic lenses that may be configured to focus the primary beams 211, 212, 213. The objective lens array 241 may be proximate the sample 208.

The control lens array 250 may be upbeam of the objective lens array 241. The control lens array 250 may comprise a stack of plates 261, for example at least three plates 261. The control lens array 250 may be configured to control electron-optical parameters of the primary beams 211, 212, 213. In an embodiment, the most downbeam plate of the control lens array 250 is the most upbeam plate of the objective lens array 241. Alternatively, the control lens array 250 may be considered to be part of the objective lens array 241. The control lens array may provide one or more additional degrees in electron-optical freedom such as in pre-focusing, magnification and beam current setting.

The stack of plates 261 of the objective lens array 241 may be referred to as an objective lens assembly. The objective lens assembly may comprise one or more of the beam limiting aperture array 252, the control lens array 250, a corrector array (not shown), the collimator array 271, the beam shaper array 242 and the detector array 240 in addition to the objective lens array 241. The objective lens assembly may comprise additional plates having lens functionality providing additional degrees of electron-optical freedom. A control lens array may be comprised by such an additional plate.

In an embodiment the detector array 240 may be integrated into the objective lens array 241. Alternatively (or additionally) the detector array 240 may be upbeam of the bottom surface of the electron-optical device 230. For example, the detector array 240 may be within the objective lens assembly or even upbeam of the objective lens assembly. For example, the detector array 240 may be in or upbeam of the objective lens array 241.

The disclosures in EP 3869535 A1 and WO 2021165136 A1 of a source, an objective lens array and a detector array are hereby incorporated by reference. The disclosure in WO2022058252 A1 of the collimator array, the macro condenser lens, the macro scan deflector, and the need for a beam limiting aperture array and a beam shaper array is incorporated by reference.

The electron-optical device 230 may comprise one or more corrector arrays (not shown) configured to at least partly correct one or more types of aberration of the beams. Such corrector arrays may be associated with or integrated into the control lens array 250, the collimator array 271 and/or the objective lens array 241, for example as part of the objective lens assembly.

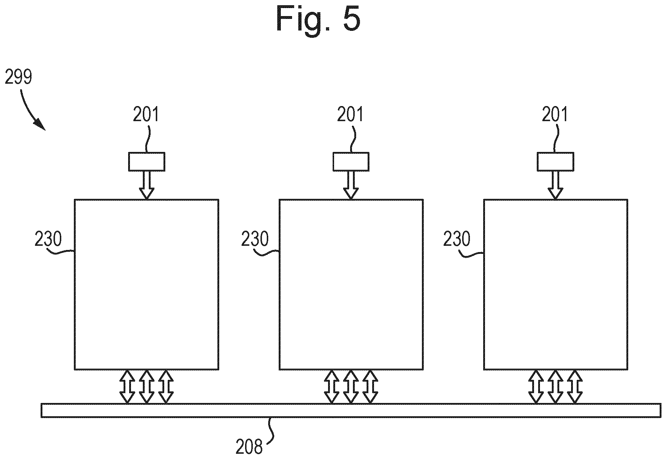

Figure 5 schematically depicts an electron-optical device array 299. In an embodiment the assessment apparatus 100 of Figure 1 comprises the electron-optical device array 299 instead of the electron-optical apparatus 140. Such an electron-optical device array 299 is also referred to as a multi-column array. The different columns (or electron-optical devices 230) may comprise in use a plurality of beams such as a beam grid. In an embodiment the electron-optical device array 299 comprises a plurality of electron-optical devices 230 of the type shown in Figure 2. A projection assembly 60 may be arranged to direct a light beam 62 such that the light beam 62 enters between one or more of the electron-optical devices 230 and the sample 208, even though this is not shown in Figure 5.

In an embodiment, one or more electron-optical elements may be shared between more than one of the electron-optical devices 230 of the electron-optical device array 299. The electron-optical elements may comprise one or more plates 261 in which a plurality of beam apertures 266 are defined for respective beam paths. In an embodiment, one or more sources 201 may be shared between more than one of the electron-optical devices 230 of the electron-optical device array 299. The sources may be comprised in a source array having different sources generating a source beam for different respective electron-optical device 230.

The electron-optical devices 230 may focus respective multi-beams simultaneously onto different regions of the same sample 208. In a different embodiment, the electron-optical devices 230 of the electron-optical device array 299 may project respective single beams towards the sample 208.

Each electron-optical device 230 of the electron-optical device array 299 may be configured in any of the ways described herein. The disclosure in WO 2022008286 A1 of how the objective lens is incorporated and adapted for use in the multi-device arrangement is hereby incorporated by reference. The disclosure in WO 2021165135 A1 of a multi-device arrangement of a multi-beam device comprising a collimator at, or proximate to, an intermediate focus is hereby incorporated by reference.

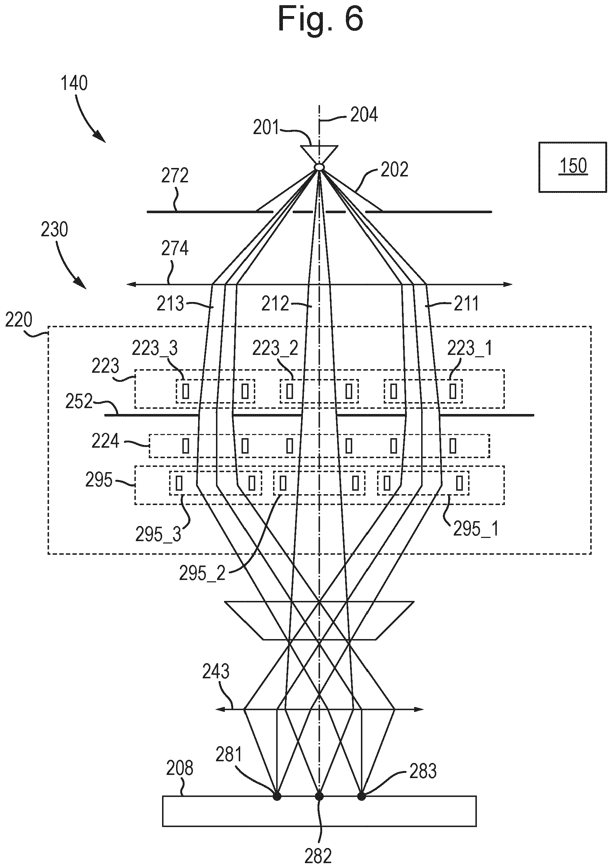

Figure 6 schematically depicts an electron-optical apparatus 140 of an assessment apparatus, e.g. the assessment apparatus 100 of Figure 1. The electron-optical apparatus 140 comprises an electron-optical device 230. The field of view of the electron-optical device 230 may be, for example, of the order of 100s of microns across the primary beams 211, 212, 213 at the sample 208. The electron-optical apparatus 140 of Figure 6 may be the electron-optical apparatus 140 of Figure 2 in which the electron-optical device 230 comprises a Coulomb aperture array 272, a macro condenser lens 274, a source converter (or micro-optical array) 220 and an objective lens 243. The electron-optical apparatus 140 defines an electron-optical axis 204. The Coulomb aperture array 272 may be referred to as a beam former array.

The source 201 generates a source beam 202. The Coulomb aperture array 272 defines a plurality of primary beams 211, 212, 213 from the source beam 202. The Coulomb aperture array 272, in operation, is configured to block off peripheral electrons to reduce electron-electron interactions (also referred to as Coulomb interactions) that may generate aberrations.

The macro condenser lens 274 is configured to at least partly collimate the primary beams 211, 212, 213. In an embodiment the macro condenser lens 274 is magnetic. The macro condenser lens 274 may be a non-rotational condenser lens. In an embodiment the macro condenser lens 274 is configured to operate on a plurality of, optionally all of, the primary beams 211, 212, 213.

The source converter 220 is configured to convert the primary beams 211, 212, 213 transmitted by the Coulomb aperture array 272 into the beams that are directed towards the sample 208. In an embodiment the source converter 220 is a module. Alternatively, the source converter 220 may comprise a plurality of separate electron-optical elements.

In an embodiment the source converter 220 comprises a pre-bending deflector array 223 with pre-bending deflectors 223_1, 223_2, 223_3 configured to deflect respective primary beams 211, 212, 213 toward a beam limiting aperture array 252.

In an embodiment the source converter 220 comprises a beam limiting aperture array 252 with an aperture pattern (i.e. apertures arranged in a formation) configured to define the outer dimensions of the primary beams 211, 212, 213 directed towards the sample 208. The beam limiting aperture array 252 may be a plate 261. In an embodiment, the beam limiting aperture array 252 defines a plurality of beams from each of the primary beams 211, 212, 213 directed to the beam limiting aperture array 252. In an alternative embodiment, the beam limiting aperture array 252 maintains the number of the primary beams 211, 212, 213 incident on the beam limiting aperture array 252.

The source converter 220 may comprise a corrector array such as an aberration reduction array 224 configured to reduce aberrations of the primary beams 211, 212, 213. In an embodiment the aberration reduction array 224 comprises a plurality of lenses configured to operate on respective primary beams 211, 212, 213. The aberration reduction array 224 may, for example, comprise a field curvature compensator array (not shown) comprising lenses. The aberration reduction array 224 may comprise an astigmatism compensator array (not shown) comprising stigmators. The stigmators may, for example, be controlled to operate on the primary beams 211, 212, 213 to reduce astigmatism aberrations.

The source converter 220 may comprise a deflector array 295 comprising deflectors 295_1, 295_2, 295_3 for the beam paths of respective primary beams 211, 212, 213. The deflectors 295_1, 295_2, 295_3 are configured to deflect the beam paths of the primary beams 211, 212, 213 towards the front focal plane of the objective lens 243 to ensure that the individual primary beams 211, 212, 213 will impinge on the sample 208 substantially perpendicular.

In an embodiment the objective lens 243 is magnetic. In an embodiment the objective lens 243 is a macroscopic lens configured to manipulate a plurality of, optionally all of, the primary beams 211, 212, 213 simultaneously. The objective lens 243 focuses the primary beams 211, 212, 213 onto the surface of the sample 208. The primary beams 211, 212, 213 form respective probe spots 281, 282, 283 on the surface of the sample 208. The deflectors 295_1, 295_2, 295_3 of the deflector array 295 deflect the individual primary beams 211, 212, 213 to the front focal plane of the objective lens to ensure that the individual primary beams 211, 212, 213, in use, impinge on the substrate 208 substantially perpendicular. In an embodiment the objective lens 243 is a macroscopic lens containing both magnetic and electrostatic lenses. In such an embodiment the macroscopic electrostatic lenses manipulate the plurality of the primary beams 211, 212, 213 simultaneously. In a further embodiment, the objective lens 243 comprises one or more scan deflectors (electrostatic and/or magnetic) to scan the plurality of primary beams 211, 212, 213 over the substrate 208.

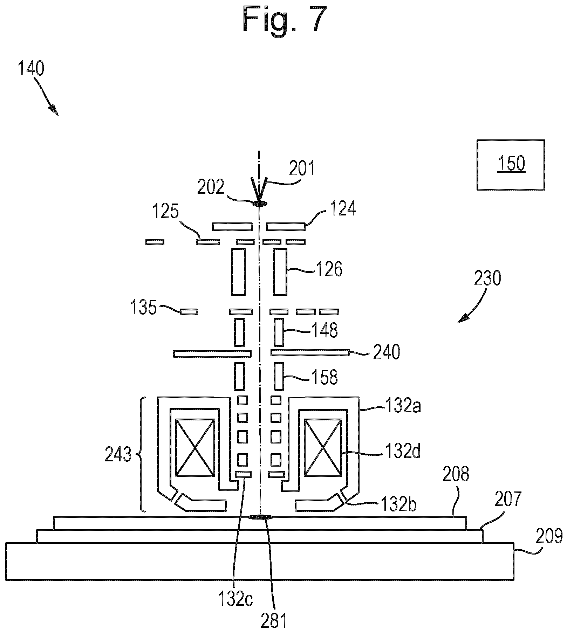

Figure 7 schematically depicts an electron-optical apparatus 140 of an assessment apparatus, e.g. the assessment apparatus 100 of Figure 1. As shown in Figure 7, in an embodiment the electron-optical apparatus 140 comprises an electron-optical device 230 that comprises a beam limit aperture 125 (the image actually shows an array of selectable beam limiting apertures), a condenser lens 126, a column aperture 135 (again indicated as an array of selectable column apertures 135), an objective lens 243 and a detector array 240.

The source 201 is configured to generate a source beam 202. A gun aperture 124 blocks peripheral electrons of the source beam 202. The source beam 202 passes through the beam limit aperture 125, the condenser lens 126 and the column aperture 135. The condenser lens 126 may be magnetic, electrostatic or a combination of magnetic and electrostatic.

In an embodiment the electron-optical device 230 comprises electromagnetic multipole, e.g. quadrupole, electron lenses. For example, the electron-optical device 230 may comprise a first multipole lens 148 and a second multipole lens 158. In an embodiment, the first multipole lens 148 and the second multipole lens 158 are used for controlling the source beam 202. For example, the first multipole lens 148 may be configured to adjust the beam current of the source beam 202. The second multipole lens 158 may be configured to adjust the size of the probe spot 281 and/or the shape of the source beam 202.

The objective lens 243 focuses the source beam 202 onto the sample 208. In an embodiment the objective lens 243 comprises a pole piece 132a, a control electrode 132b, a deflector 132c and an exciting coil 132d. In an embodiment a deflector, such as the deflector 132c or other deflectors in the objective lens 243 are configured to scan the source beam 202 across the surface of the sample 208. The detector array 240 is configured to detect signal electrons from the sample 208.

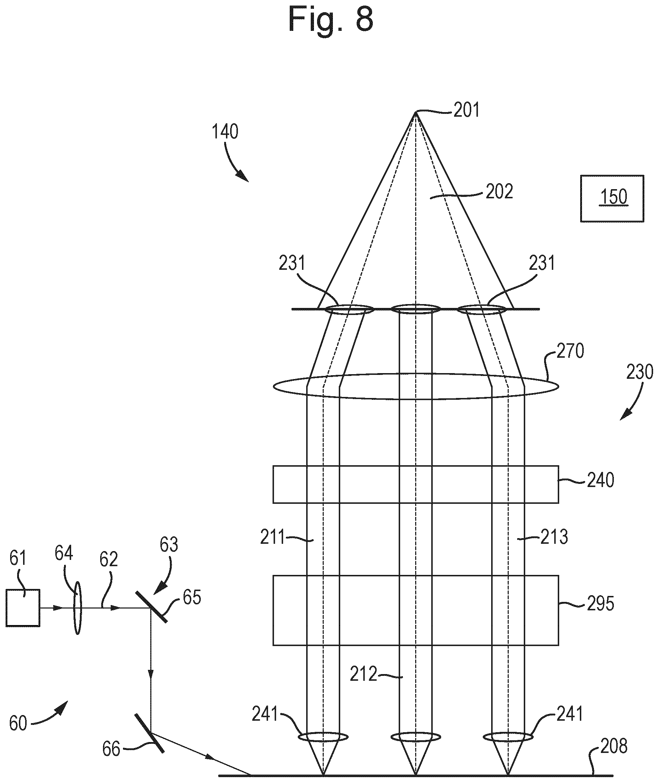

Figure 8 schematically depicts an electron-optical apparatus 140 of an assessment apparatus, e.g. the assessment apparatus 100 of Figure 1. The electron-optical apparatus 140 may be the electron-optical apparatus 140 of Figure 2 in which the electron-optical device 230 comprises a condenser lens array 231, a macro collimator 270, the detector array 240, a deflector array 295 and an objective lens array 241.

Features that are the same as those described above are given the same reference numerals. For conciseness, such features are not described in detail with reference to Figure 8. For example, the source 201, the condenser lens array 231, the objective lens array 241 and the sample 208 may be as described above.

The source is configured to generate a source beam 202. The condenser lens array 231 is configured to define a plurality of primary beams 211, 212, 213 from the source beam 202. The disclosure in EP1602121A1 of a lens array to split a beam into a plurality of beams, with the lens array providing a lens for each beam is hereby incorporated by reference as a possible implementation of the condenser lens array 231.

In an embodiment the condenser lens array 231 comprises three plates 261 configured as an Einzel lens. An Einzel lens is configured to substantially ensure that the energy of an electron leaving the lens is the same as when the electron arrived at the lens. Such a lens maintains the energy of an electron between arriving and leaving the lens, for example the condenser lenses of the condenser lens array 231. Thus, dispersion only occurs within the condenser lens array 231 itself, thereby limiting chromatic aberrations. When a distance between the three plates of the Einzel lens is small, the chromatic aberrations caused by this condenser lens array 231 is limited, e.g. having a negligible effect.

In an embodiment the electron-optical device 230 comprises a collimator which may be macro collimator 270. The macro collimator 270 bends respective beams by an amount effective to ensure that a beam axis of each of the primary beams 211, 212, 213 derived from the primary 202 beam is incident on the sample 208 substantially normally (i.e. at substantially 90° to the nominal surface of the sample 208). In the current embodiment, the macro collimator 270 acts on all of the primary beams 211, 212, 213. The macro collimator 270 may comprise an electrostatic lens and/or a magnetic lens arrangement comprising a plurality of lens elements (e.g. a plurality of electrostatic and/or magnetic elements, e.g. forming a multipole).

In an embodiment the detector array 240 is configured to detect signal electrons by reference to the energy of the signal electron. For example, scintillators e.g. YAG do not directly detect electrons but generate light which is then detected. The signal electrons emitted from the sample 208 gain energy from the electromagnetic fields between the detector array 240 and the sample 208. In an embodiment, the objective lens array 241 is located between the detector array 240 and the sample 208.

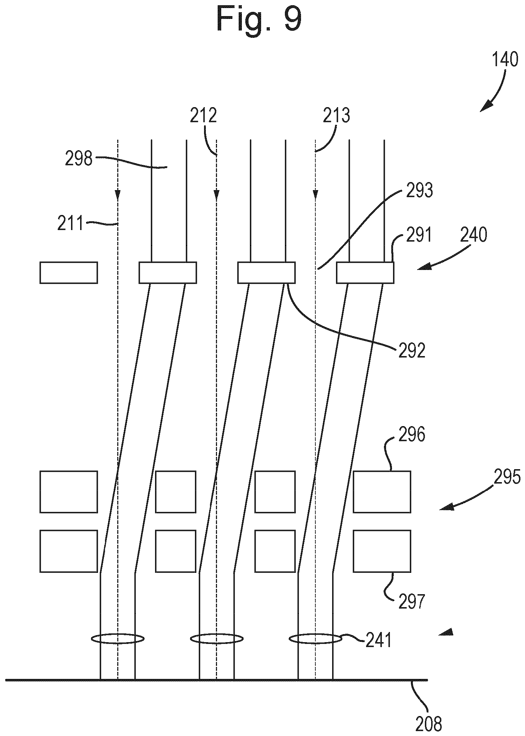

The electron-optical device 230 may comprise a deflector array 295 located between the detector array 240 and the objective lens array 241. The deflector array 295 may be referred to as a beam separator. The deflector array 295 may deflect signal electrons resulting from individual primary beams 211, 212, 213 along a path towards detector elements of a detector array 240 that is away from the paths of the primary beams towards the sample 208. The deflector array 295 may comprise a magnetic deflector array that is configured to provide magnetic fields to disentangle the primary electrons projected toward the sample 208 from the signal (e.g. secondary) electrons emitted from the sample 208. The deflector array 295 may comprise a Wien filter array. The deflector array 295 may comprise an electrostatic deflector array that is arranged to cooperate with the magnetic deflector array to achieve the disentangling of the paths of the primary electrons and signal electrons. Figure 9 is a close-up view of part of the electron-optical device 230 shown in Figure 8. In an embodiment the detector array 240 comprises an electron to photon converter array 291, e.g. a scintillator array. The electron to photon converter array 291 comprises a plurality of fluorescent elements (e.g. comprising YAG) which may be in the form of fluorescent strips 292 extending across the beam grid. Each fluorescent strip 292 is located in the plane of the electron to photon converter array 291. At least one fluorescent strip 292 is arranged between two adjacent primary beams 211, 212, 213 projected towards the sample 208. In an embodiment, the fluorescent strips 292 extend substantially across the beam grid. Alternatively, the electron to photon converter array 291 may comprise a plate of a fluorescent material with openings 293 for the primary beams 211, 212, 213 or an array of elements of similar size around the beams and that may be spaced apart. The primary beams 211, 212, 213 are projected through the plane of the electron to photon converter array 291, e.g. via the openings 293 such as between the fluorescent strips 292, towards the deflector array 295.

In an embodiment the deflector array 295 comprises a magnetic deflector 296 and an electrostatic deflector 297. The electrostatic deflector 297 is configured to counteract the deflection of the magnetic deflector 296 for the primary beams 211, 212, 213 transmitted towards the sample 208. Accordingly, the primary beams 211, 212, 213 may be shifted to a small extent in the horizontal plane. The beam paths downbeam of the deflector array 295 are substantially parallel to the beam paths upbeam of the deflector array 295.

In an embodiment the objective lens array 241 comprises a plurality of plates for guiding signal electrons emitted from the sample 208 towards the deflector array 295. For the signal electrons, which travel in opposite direction with respect to the projected primary beams 211, 212, 213, the electrostatic deflector 297 does not counteract the deflection of the magnetic deflector 296. Instead, the deflections of the secondary electrons by the electrostatic deflector 297 and the magnetic deflector 296 add up. Accordingly, the signal electrons are deflected to travel at an angle with respect to the optical axis in order to transmit the secondary electrons onto the fluorescent strips 292 of the detector array 240.

At the fluorescent strips 292, photons are created upon incidence of the signal electrons. In an embodiment, the photons are transported from the fluorescent strip 292 to a photo detector (not shown) via a photon transport unit. In an embodiment, the photon transport unit comprises an array of optical fibers 298. Each optical fiber 298 comprises an end which is arranged adjacent or attached to one of the fluorescent strips 292 for coupling photons from the fluorescent strip 292 into the optical fiber 298, and another end which is arranged to project photons from the optical fiber 298 onto the photo detector. In a different arrangement, the optical to electrical converter (or photo diode) is located immediately adjacent the electron to light converter, avoiding the need for optical fibers.

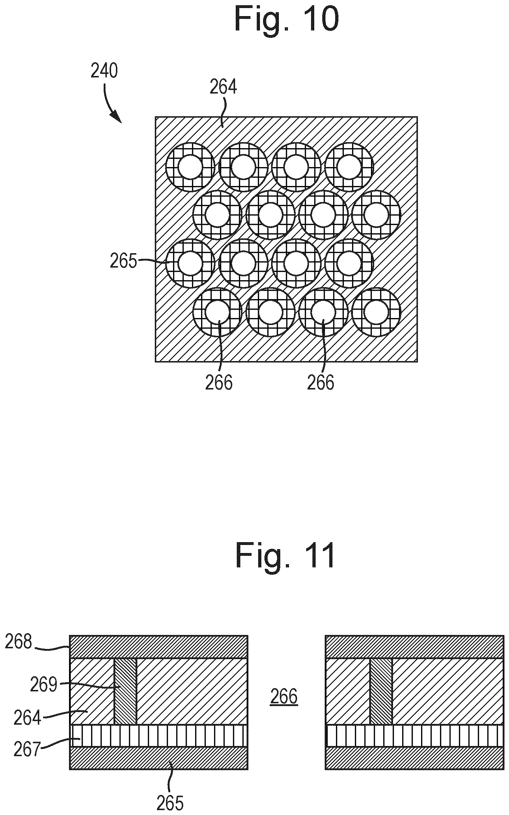

Figure 10 is a bottom view of the detector array 240 which comprises a detector substrate 264 on which are provided a plurality of detector elements 265 each surrounding a beam aperture 266. The detector array 240 may be provided at a downbeam surface of a plate 261 comprising beam apertures 266. In an embodiment, the detector elements 265 are charge capture electrodes, for example metal plates. The beam apertures 266 may be formed by etching through the detector substrate 264. In the arrangement shown in Figure 10, the beam apertures 266 are in a hexagonal close packed array. The beam apertures 266 can also be differently arranged, e.g. in a rectangular array.

Figure 11 depicts at a larger scale a part of the detector array 240 in cross section. The detector elements 265 form the bottom surface, i.e. the surface the closest to the sample 208, of the detector array 240. Between the detector elements 265 and the main body of the detector substrate 264 a logic layer 267 may be provided. At least part of the signal processing system, for example for amplification, may be incorporated into the logic layer 267.

A wiring layer 268 is provided on the backside of, or within, the detector substrate 264 and connected to the logic layer 267 by through-substrate vias 269. The number of through-substrate vias 269 need not be the same as the number of beam apertures 266. In particular if the electrode signals are digitized in the logic layer 267 only a small number of through-silicon vias may be required to provide a data bus. The wiring layer 268 may include control lines, data lines and power lines. It will be noted that in spite of the beam apertures 266 there is ample space for all necessary connections. The detector array 240 may be fabricated using CMOS technology, but may also be fabricated using bipolar or other manufacturing techniques. A printed circuit board and/or other semiconductor chips may be provided on the detector array 240.

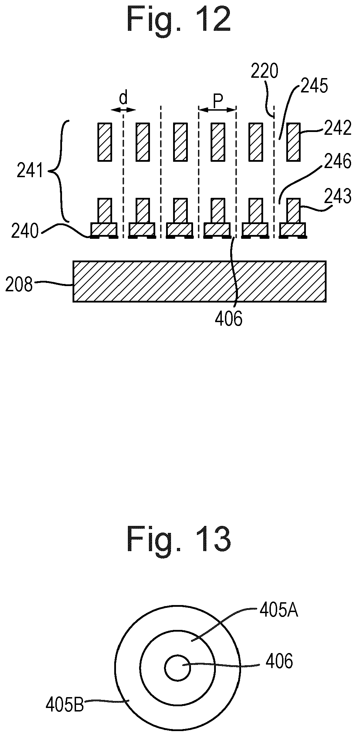

The objective lens array 241 of the electron-optical device 230 of any embodiment may comprise at least two electrodes in which are defined aperture arrays. In other words, the objective lens array comprises at least two electrodes with a plurality of holes or apertures. FIG. 12 shows electrodes 242, 243 which are part of an exemplary objective lens array 241 having respective aperture arrays 245, 246. The position of each aperture in an electrode corresponds to the position of a corresponding aperture in another electrode. The corresponding apertures operate in use on the same beam, sub-beam or group of beams in the multi-beam. In other words, corresponding apertures in the at least two electrodes are aligned with and arranged along a sub-beam path, i.e. one of the sub-beam paths 220. Thus, the electrodes are each provided with apertures through which the respective sub-beam 211, 212, 213 propagates. A projection assembly 60 may be arranged to direct a light beam 62 such that the light beam 62 enters between the components of the electron-optical device 230 and the sample 208.

As shown in FIG. 13, the detector element 405, in which an aperture 406 is defined and configured for the through passage of a charged particle beam, may comprise an inner detecting portion 405A and an outer detecting portion 405B. The inner detecting portion 405A surrounds the aperture 406 of the detector. The outer detecting portion 405B is radially outwards of the inner detecting portion 405A. The shape of the detector may be generally circular. Thus, the inner detecting portion and the outer detecting portion may be concentric rings.

As mentioned above, the projection assembly 60 functions as an ACC module to illuminate a light beam 62, such as a laser beam, on the sample 208. By illuminating the sample 208 with a light beam 62 while performing the electron beam defect inspection the defect contrast is significantly improved.

A known projection assembly 60 is described with reference to FIGs. 14-17.

FIG. 14 is a schematic diagram of a light beam 62 entering between the electron-optical device 230 and the sample 208 according to an embodiment. In an embodiment the electron-optical apparatus 140 comprises a sample holder 207 (not shown) configured to hold a sample 208. The sample 208 has a surface facing the electron-optical device 230. The electron-optical device 230 is configured to project an electron beam 211, 212, 213 towards the sample 208. The electron-optical device 230 is configured to deflect each of the electron beams 211, 212, 213 over a field of view of the surface of the sample 208.

The electron-optical device 230 has a facing surface 72 facing the sample holder 207. In use, the facing surface 72 faces the sample 208. The facing surface 72 is at the most down-beam part of the electron-optical device 230.

The electron-optical apparatus 140 comprises the projection assembly 60. In an embodiment the projection assembly 60 is arranged to direct a light beam 62 along a light path such that the light beam 62 reflects off the facing surface 72 up-beam, with respect to the light path, of being incident on the portion 71 of the surface of the sample 208.

The system shown on FIG. 14 is expected to achieve coupling of the light beam 62 through the gap 70 even when the gap 70 is particularly narrow such as less than or equal to approximately 50 µm.

As shown in FIG. 14, in an embodiment the light beam 62 at least covers the portion 71 of the surface of the sample 208 corresponding to the field of view of the electron beam 211, 212, 213. With this embodiment, it is possible to achieve improved defect contrast for the electron beam 211, 212, 213. This is possible for a single beam and for a multi-beam.

FIG. 15 is a diagram explaining focus angle α of a light beam 62 entering between the electron-optical device 230 and the sample 208 according to an embodiment. As shown in FIG. 15, in an embodiment the projection system 60 comprises a light source 61. The light source 61 is configured to emit the light beam 62. A cylindrical lens 64 may be provided to focus the light beam 62 more in one direction than in an orthogonal direction. In an embodiment the light source 61 is a laser light source. In an embodiment the light source 61 is configured to emit a light beam 62 having a wavelength in the range of 900 nm or less. In an example, the wavelength may be equal to or greater than 450nm. According to some embodiments of the present invention, a central wavelength may be equal to or greater than 450nm and equal to or less than 900nm.

As shown in FIGs. 2-5 and FIG. 8, in an embodiment the projection assembly 60 comprises an optical system 63. In an embodiment the optical system 63 is configured to focus the light beam 62 to be narrower in a direction perpendicular to the facing surface 72 than in a direction parallel to the facing surface 72 and perpendicular to an axis of the light beam 62. The direction perpendicular to the facing surface 72 is perpendicular to the sample 208, i.e. the up-and-down direction in the view of FIG. 15. The direction parallel to the facing surface 72 and perpendicular to the axis of the light beam 62 is the direction into and out of the diagram in the view of FIG. 15. The axis of the light beam 62 is the primary direction in which the light beam 62 projects and is shown as a dot-chain line in FIG. 14.

In one direction, the light beam 62 can be relatively broad. For example, in an embodiment the light beam has a breadth of at least 1 mm, optionally at least 2 mm, optionally at least 5 mm, optionally at least 10 mm and optionally at least 20 mm in one direction. In the other direction, the light beam 62 is focused into the gap 70. The light beam 62 may have a breadth in this other direction of at most 500 µm, optionally at most 200 µm, optionally at most 100 µm and optionally at most 50 µm. The breadth of the light beam 62 varies along its length because it is focused. The breadth measurements mentioned above are of the light beam 62 at the position along its axis where it enters the gap 70.

By focusing the light beam 62 into the gap 70, a greater intensity of light of the light beam 62 can reach the sample 208. This can help to improve the contrast when detecting defects on the sample 208.

In an alternative embodiment the light beam 62 is not focused more in one direction than another. Such an arrangement simplifies the projection system 60. However, particularly for a narrow gap 70 some of the light beam 62 may not reach into the gap 70. Some of the light beam 62 may be prevented from entering into the gap 70. As a result a greater portion fails to reach the intended portion 71 of the sample surface.

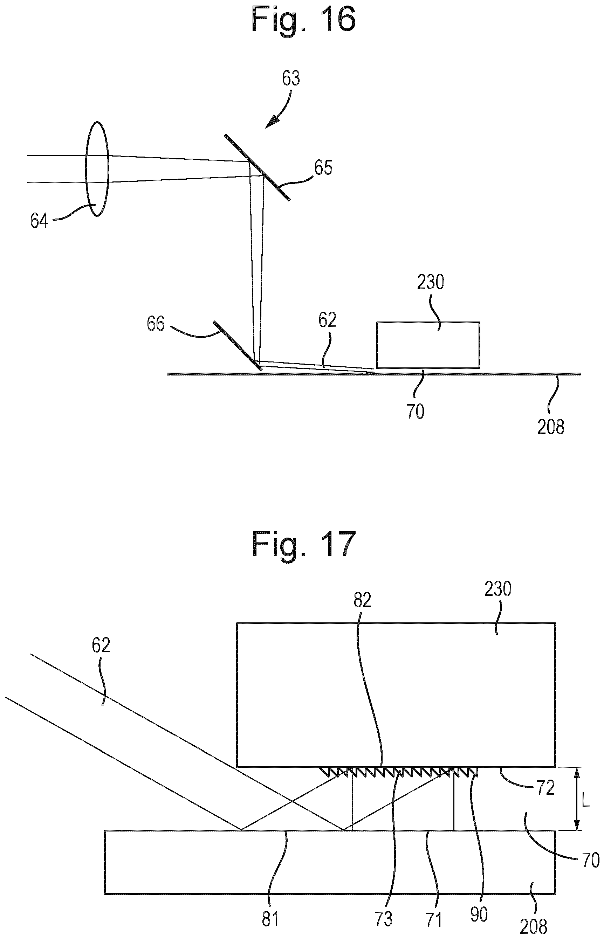

As shown in FIG. 16, in an embodiment the optical system 63 is configured to focus the light beam 62 such that the light beam 62 fits the gap 70 for example within an entrance to the gap. The light beam 62 has approximately the same dimension as the gap 70 in the direction perpendicular to the sample 208 where the light beam 62 enters the gap 70. Substantially all of the light beam 62 enters the gap 70. This focusing of the light beam 62 reduces the proportion of the light beam 62 that is wasted, for example that does not enter the gap 70. In an alternative embodiment the cross-section of the light beam is larger than the entrance to the gap, for example in a direction orthogonal to the facing surface. In this arrangement some of the light beam does not fit into the gap 70.

In an embodiment the projection assembly 60 is arranged relative to the gap 70 such that where the light beam 62 enters the gap 70, the light beam 62 extends along most of the gap 70 in a direction perpendicular to the facing surface 72. The gap 70 is relatively narrow such that the light beam 62 fills most, and preferably all, of the height of the gap 70. For example, in an embodiment the gap 70 is about 50µm and the light beam 62 extends over more than 25 µm, and preferably all 50 µm, of the gap 70. In an embodiment the gap 70 is about 20 µm and the light beam 62 extends over more than 10 µm, and preferably all 20 µm, of the gap 70. However, in an alternative embodiment the gap 70 is much higher. For example, in an embodiment the gap 70 is at least 0.75 mm, optionally at least 1 mm and optionally about 1.5 mm. The light beam 62 may not extend across most of the gap 70. For example, in an embodiment the light beam extends at most 200 µm, optionally at most 100 µm, and optionally at most 50 µm along the gap 70 in a direction perpendicular to the facing surface 72.

In an embodiment the projection assembly 60 is configured such that an axis angle β (see FIG. 14) of the light beam 62 is greater than the focus angle α of the light beam 62. As shown in FIG. 14, the axis angle β is defined between a surface of the sample 208 (or the sample holder 207) facing the electron-optical system 230 and the axis of the light beam 62 immediately up-beam of its entry between the electron-optical system and the sample 208 (or the sample holder 207). The axis angle β may be referred to as the grazing angle of the path of the light beam relative to the sample holder 207. The angle of incidence of the path of the light beam is defined relative to the normal of the sample surface. Further up-beam of the entry point, the light beam 62 may, for example, be folded as shown in FIGs. 2-5 and FIG. 8. However, immediately up-beam of the entry point the light beam 62 is not folded such that the axis of the light beam is a straight line. The axis angle β is the angle of the axis of the light beam 62 with respect to the surface of the sample 208.

As shown in FIG. 15, the focus angle α is defined as a taper angle of the light beam 62 caused by the optical system 63 focusing the light beam 62. The focus angle α relates to the focusing of the light beam 62 in the plane in which the light beam 62 is maximally focused, i.e. the plane of the diagram in the view of FIG. 15. The focus angle α may alternatively be referred to as the internal opening angle of the light beam 62. The focus angle α is related to how narrowly the light beam 62 focused into the gap 70. A greater value of the focus angle α is related to less diffraction of the light beam 62. This affects the size of the spot formed by the light beam 62. The size of a diffraction limited spot is proportional to the wavelength of the light of the light beam. The size of a diffraction limited spot is inversely proportional to the focus angle α.

FIG. 16 is a schematic diagram of a projection assembly 60 projecting a light beam 62 entering between the electron-optical device 230 and the sample 208 according to an embodiment. By providing that the axis angle β is greater than the focus angle α, the light beam 62 can have a downward (i.e. towards the sample 208) trajectory immediately up-beam of where the light beam enters the gap 70. The light beam 62 enters the gap 70 from the side of the gap 70. This increase the design freedom of where the projection assembly 60 can be positioned relative to the sample 208. For example, the last component of the optical system 63 of the projection assembly 60 can be positioned above the sample 208 as shown in FIG. 16.

As shown in FIG. 16, in an embodiment the optical system 63 comprises reflecting surfaces 65, 66 such as mirrors. For example two reflecting surfaces 65, 66 may be provided. In an alternative embodiment, the optical system 63 does not reflect the light beam 62. The light beam 62 may be directed straight to the gap 70. In an alternative embodiment the optical system 63 may comprise one, three or more than three reflecting surfaces. The number and arrangement of the reflecting surfaces may be chosen depending on the dimensions of the volume in which the projection system 60 is required to fit.

However, it is not essential for the axis angle β to be greater than the focus angle α. In an alternative embodiment the last component of the optical system 63 of the projection assembly 60 is positioned below the level of the upper surface of the sample 208. In an alternative embodiment, the projection assembly 60 is arranged such that the light beam is first incident on the facing surface 72 rather than on the sample 208.

FIG. 17 is a schematic diagram of a light beam 62 entering between the electron-optical device 230 and the sample 208 according to an embodiment. As shown in FIG. 17, in an embodiment the facing surface 72 comprises a surface topography 90, for example as a topographical region, so as to reflect the light beam 62 towards the sample 208. The facing surface 72 is generally planar. In an embodiment the facing surface 72 away from the topographical region has a surface angle of at most 20°, optionally at most 10°, optionally at most 5°, optionally at most 2° and optionally at most 1° for at least 50%, optionally at least 80% and optionally at least 90% of the facing surface 72. The surface topography 90 is intentionally angled relative to the plane of the facing surface, i.e. non-planar, so as to control the direction in which the light beam 62 reflects.

As shown in FIG. 17, in an embodiment the projection assembly 60 is positioned relative to the electron-optical device 41 and the sample 208 held by sample holder 207 so that the projection assembly 60 directs the light beam 62 such that its most down-beam, with respect to the light path, reflection 82 off the facing surface 72 up-beam of being incident on the portion 71 of the surface of the sample is at a topographical region 73 facing the portion 71. The topographical region 73 is part of the facing portion that faces the portion 71. Lines that are perpendicular to the portion pass through the topographical region 73. In an embodiment the projection assembly 60 is arranged to direct the light beam 62 such that the light beam 62 reflects off the topographical region 73.

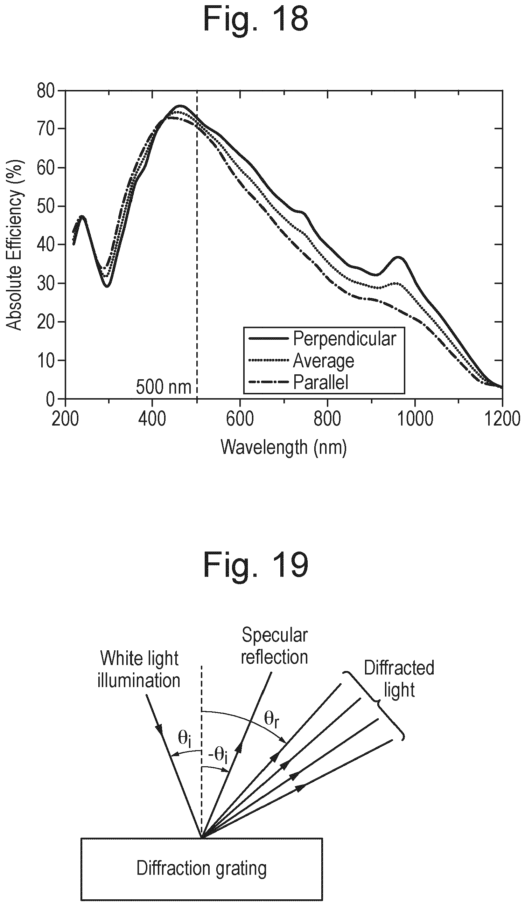

Reference is now made to FIG. 18 and FIG. 19. The typical efficiency and/or diffraction angle may be different for various wavelengths for a given angle of incidence. For example, FIG. 18 shows the diffraction efficiency of a commercially-available blazed diffraction grating (namely, Thorlabs item No. GR25-0305) as a function of the wavelength. This absolute efficiency is the percentage of incident monochromatic radiation on a grating that is diffracted into the desired order. FIG. 18 shows the absolute efficiency for various polarization states of the incident light beam. The three curves labeled "parallel", "perpendicular" and "average" refer to the polarization state. Here, parallel and perpendicular polarization are defined as the orientation of the electric field vector with respect to the lines of the grating.

FIG. 19 is a schematic representation of typical chromatic dispersion of a diffractive element showing that the diffraction angle (θᵣ) is different for different optical wavelengths.

ACC modules according to the prior art may exhibit dispersive phenomena that prevent the system from adequately regulating accumulation charges on the sample. For example, when an ACC module directs a beam of white light, the different wavelengths making up the white light will be diffracted at different angles. This is illustrated in the schematic in FIG. 19, in which for an angle of white light incidence θi, different constituent wavelengths are reflected at a different reflection angle θr.

Use of multiple wavelengths for illuminating a sample surface may be advantageous, as it may lead to improved regulation of charge build up on the sample surface. It may be desirable to select one or more specific wavelengths for a particular inspection recipe, depending on the nature of the sample to be inspected and the structures formed in it. However, known ACC modules may not be effective at guiding different wavelengths along a substantial portion of the sample surface or the entire sample surface. Known ACC modules may also not be particularly effective at flooding the surface of the sample with multiple wavelengths, due to the dispersive phenomena.

Known ACC modules may not provide homogeneous illumination across the whole sample surface, which may lead to regions of charge build up on the sample surface. This may occur because known ACC modules do not provide a means for directing the light along a particular light path. Accordingly, the light may disperse and travel in an unpredicted direction.

According to the present disclosure, there is provided a charged particle assessment system comprising a projection assembly which can alleviate or prevent problems with known ACC modules.

According to an embodiment of the present disclosure, there is provided a charged particle assessment system comprising a sample holder configured to hold a sample having a surface; a charged particle-optical device configured to project a charged particle beam towards the sample, the charged particle-optical device being configured to deflect the charged particle beam over a part of the surface of the sample, the charged particle-optical device having a device surface, the device surface facing, in use, the surface of the toward the sample holder; a projection assembly arranged to direct a plurality of light beams along respective light paths, wherein the plurality of light beams include light beams having different wavelengths; and wherein the device surface comprises a plurality of redirecting elements corresponding to the number of light beams, each of the redirecting elements being associated with one of the respective wavelengths, wherein each of the redirecting elements is configured to direct light onto the sample.

The present disclosure provides a projection assembly arranged to direct a plurality of light beams along respective lights paths, the plurality of light beams having different wavelengths. The plurality of light beams may all have different wavelengths, or two or more of the wavelengths may be the same. The respective light paths may be defined as different paths along the sample surface, each of the respective light paths following a different direction along the sample surface.

Each of the plurality of light beams are directed along different respective paths via a plurality of redirecting elements, each of the redirecting elements being associated with one of the respective wavelengths. In other words, each of the redirecting elements is associated with a light beam having a wavelength. In an embodiment, each redirecting element may be associated with a range of wavelengths. As shown in FIG. 18, a redirecting element may be particularly effective at redirecting a range of wavelengths centered on a central wavelength. The redirecting elements each direct the associated wavelength or range of wavelengths along a respective light path and direct the associated light beam toward the sample.

By directing light beams along predetermined light paths and towards the sample surface, the sample surface can be illuminated homogeneously with each of the wavelengths. By illuminating different wavelengths along different light paths by using redirecting elements associated with each wavelength or range of wavelengths, the undesirable effects associated with dispersive phenomena can be avoided.

According to an embodiment of the present invention, the redirecting element may be associated with one wavelength along one direction of the redirecting element surface and another wavelength along another direction of the redirecting element surface. For example, a plurality of redirecting elements may be configured such that each of the redirecting elements directs the plurality of light beams along their respective paths. In other words, the redirecting element may be associated with a plurality of wavelengths (or a plurality of central wavelengths, as explained below).

The redirecting element may have a plurality of directions on each surface, each direction being associated with a particular wavelength (or central wavelength). In an example, this may be a diffraction grating having protrusions which diffract different wavelengths along different directions.

Alternatively, the surface of the redirecting element may be anisotropic, meaning that the light beams may be redirected along any direction of the element surface efficiently. In an example, this may be a mirror which can reflect a plurality of light beams incident from different directions.

The redirecting element is an optical element that is configured to redirect light towards the sample. A redirecting element may be a reflective diffraction grating or a reflective element. The associated wavelength is a wavelength which the redirecting element is configured to redirect with maximum or close to maximum efficiency. For example, FIG. 18 shows the results for a diffraction grating having an associated wavelength of approximately 450 nm.

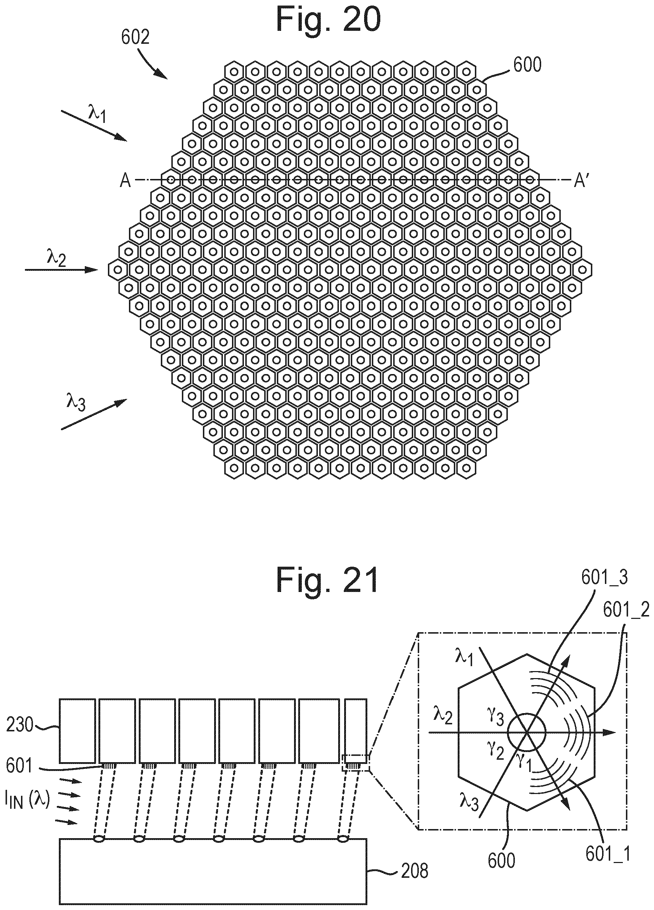

FIG. 20 illustrates a schematic of a device surface 602 of a charged particle-optical device. The device surface may comprise a number of device surface elements 600, each having at least one redirecting element disposed thereon. While FIG. 20 shows that the device surface elements 600 are separate elements, this is not necessarily the case and the device surface elements may simply be regions of the device surface 602. The term device surface element is used to refer to a region of the device surface having at least one redirecting element disposed thereon.

The device surface may correspond to a detector surface. The detector surface may be a surface of a detector for detecting interaction products from interaction of the charged particle beam with the sample. At least one of the redirecting elements may be integrated at least partially into a detector surface. In other words, the redirecting element may constitute at least part of the device surface. The number of device surface elements 600 shown in FIG. 20 is illustrative, not prescriptive. Device surface elements 600 are not necessarily hexagonal.

For example, the plurality of device surface elements 600 show in FIG. 20 may correspond to the array of detector elements 256 described with reference to FIG. 10. The redirecting elements may be integrated into the detector elements which are arranged around the beam apertures 266 (not labelled in FIG. 20).

Alternatively, the redirecting elements may be disposed on a different part of the device surface, such as the detector substrate 264 of FIG. 10 or at least part of the detector substrate 264.

A projection system and a device surface according to the present invention may be implemented in a charged particle assessment system configured to project a single charged-particle beam to the surface of the sample. Alternatively, the projection system and a device surface according to the present invention may be implemented in a charged particle assessment system configured to project a plurality of charged-particle beams to the surface of the sample. The single charged-particle beam or the plurality of charged-particle beams may be electron beams.

According to the present disclosure, a plurality of light beams are provided. The light beams include light beams having different wavelengths. Each of the wavelengths may be different from the other wavelengths. Alternatively, two or more of the wavelengths may be the same. In another embodiment, all of the wavelengths may be identical. In some embodiments, each of the light beams may comprise a plurality of wavelengths. The plurality of wavelengths in a light beam may be a range of wavelengths centered on a central wavelength. The range of wavelengths may be referred to as a wavelength bandwidth.

The light beams may be provided by any suitable means. For example, the light source 61 of projection assembly 60 may be a laser, a laser diode, semiconductor laser, superluminescent diode, a spectrally filtered supercontinuum light source, short-pulse lasers. The superluminescent diode, a spectrally filtered supercontinuum light source and short-pulse lasers may be particularly well suited for producing partially coherent light.

The plurality of light beams may comprise three light beams, such as the example shown in FIG. 20 and FIG. 21. However, the number of light beams may be different. For example, there may be two light beams, four light beams, five light beams, etc. The redirecting elements are arranged to guide each of the light beams across the sample surface. It is not necessary that all of the light beams are used simultaneously. One or more light beams may be used selectively, e.g. by selectively energizing their respective light sources, for example dependent on the sample to be assessed. If multiple light beams are used simultaneously their intensities and times of utilization may be independently controlled.

According to the present invention, the light beams may be continuously illuminated on the sample 208. Alternatively, the sample 208 may be illuminated intermittently, e.g. via pulses of light.

In FIG. 20 three light beams are provided along three directions. These light beams are labelled as λ₁, λ₂, λ₃ next to the respective directions along which they are directed (indicated by arrows).

The device surface 602 comprises a plurality of redirecting elements configured to guide each of the wavelengths λ₁, λ₂, λ₃ along the three directions indicated by the respective arrows. These may be central wavelengths. Each of the device surface elements 600 may direct a single light beam of the plurality of light beams. For example, a third of the surface elements 600 may be configured to direct wavelength λ₁, another third of the surface elements 600 may be configured to direct wavelengths λ₂, and the last third of the surface elements 600 may be configured to direct wavelengths λ₃. The distribution of the different surface elements may be selected as appropriate. For example, the different types of redirecting elements may be distributed among the surface elements 600 in a uniform matter.

In an embodiment, each of the light beams having wavelengths λ₁, λ₂, λ₃ may comprise range of wavelengths. For example, a central wavelength and a wavelength bandwidth.

In another embodiment, each of the surface elements 600 may comprise a redirecting element to direct each of the light beams. An example of this embodiment is described with reference to FIG. 21.

FIG. 21 is a schematic a schematic of a side view of the charged particle-optical device taken along line A-A' of FIG 20, also showing a cross-section of sample 208.

A light beam of intensity I_{IN}(λ) is provided. FIG. 21 shows the redirecting elements 601 directing the light beam towards the surface of sample 208 by means of dashed lines. FIG. 21 illustrates the redirecting elements 601 redirect the light toward regions of the sample, but the angles represented in FIG.21 do not necessarily accurately depict the angle at which light beam I_{IN}(λ) would be redirected towards the sample surface. It may be preferable for the light beam I_{IN}(λ) to be redirected to land underneath the aperture through which the beam passes. For example, it may be preferable to direct the light beam so that it lands on a surface of the sample directly below or in the vicinity of beam aperture 266. Accordingly, charge accumulation may be reduced or prevented in regions of the sample which are being imaged. The light beam need not be incident on the sample at exactly the same point and time as the charged particle beam. For example, the light beam may irradiate a part of the sample just before it is scanned by the charged-particle beam.

After being incident on the sample 208, the light beam is reflected towards the device surface, so that it may be incident on another redirecting element 601. Accordingly, the light beam is directed along the sample by reflecting off the sample surface and the device surface at least once (or a plurality of times), so that homogenous illumination of the sample surface is provided.

The inset of FIG. 21 shows a schematic of a device surface element 600 having a number of redirecting elements disposed thereon. In the example shown in FIG. 21, the device surface element comprises three redirecting elements 601_1, 601_2 and 601_3. Redirecting elements 601_1 is associated with λ₁. Redirecting elements 601_2 is associated with λ₂. Redirecting elements 601_3 is associated with λ₃. The device surface comprises a plurality of device surface elements 600, so that the redirecting elements are distributed across most of or all of the device surface. The redirecting elements may be associated with wavelengths of equal to or less than 900 nm. In an embodiment wherein one or more of the wavelengths comprises a central wavelength and a bandwidth, the redirecting element may be associated with the central wavelength.

The redirecting elements 601_1, 601_2 and 601_3 may be arranged on the surface element in any suitable manner. For example, they may be arranged around an aperture as shown in FIG. 21. A device surface element 600 may have a plurality of each redirecting element type disclosed on. For example, the device surface element 600 on FIG. 21 could one or more further redirecting elements 601_1 disposed along the light path of λ₁, one or more further redirecting elements 601_2 disposed along the light path of λ₂ and/or one or more further redirecting elements 601_3 disposed along the light path of λ₃. The light sources may be disposed so that the direction of each light beam is coincident with the arrangement of the associated redirecting element. In the example in FIG. 21, the light beams intersect at angles labelled γ₁, γ₂, γ₃. The angles γ₁, γ₂, γ₃ may be equal to each other, or one or more of the angles may be different. In the example shown in FIG. 21 the angles γ₁, γ₂, γ₃ are equal to each other, but this is not a necessary requirement.

While the example shown in FIG. 21 shows three light beams with three associated redirecting element types, there may be a different number of light beams each having a corresponding redirecting element.

In an example, the system may comprise two light beams, which are configured to cross at an angle or equal to or greater than 60 degrees and equal to or less than 90 degrees. Alternatively, two light beams may cross at an angle of less than 60 degrees.

In another example, the projection assembly is configured to direct three light beams, such that the angle between a given beam and any of the adjacent beams is equal to or greater than 50 and equal to or less than 70 degrees. Alternatively, the three light beams may intersect so that an angle between two of the light beams is less than 50 degrees.

The number of light beams and the angle at which they intersect may be selected as appropriate. For example, a projection assembly and device surface arranged to direct two light beams may be easier to manufacture and operate. A projection assembly and device surface arranged to direct more than two light beams may be advantageous where illumination of the sample with multiple wavelengths is desirable.

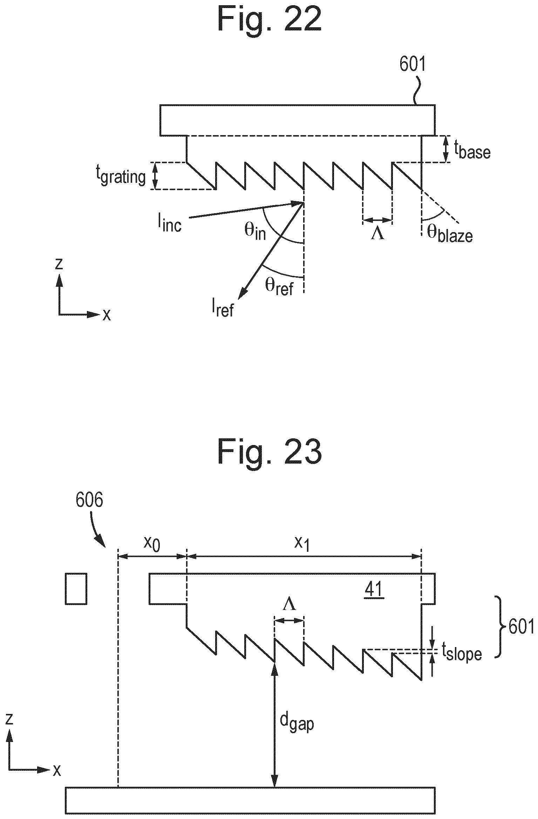

In an example, the redirecting element is a reflection diffraction grating. An example of a reflection diffraction grating is shown in FIG. 22. A reflection diffraction grating has a number of design parameters which may be varied to tune the grating to be associated with a particular wavelength. In FIG. 22, base thickness t_{base}, grating thickness t_{grating}, grating pitch Λ, and, e.g. angle θ_{blaze} may be varied to achieve the desired reflection beam of reflection intensity I_{ref} at a reflection angle θ_{ref}, for an incoming light beam of intensity I_{inc} at an angle of θᵢₙ. The diffraction grating shown in FIG. 22 is for illustration purposes only, and the number of protruding features which redirect the light towards the sample may differ from the number shown in FIG 22 and 23.

FIG. 23 shows another example of a redirecting element 601 which is a diffraction grating. The diffraction grating may be sloped (as indicated by parameter tₛₗₒₚₑ) and this parameter can be varied to tune the diffraction grating to a particular wavelength. For example, the slope of the grating may be tuned to improve some properties of the grating, such as its diffraction efficiency.

The grating pitch (i.e. spacing of protruding elements of a diffraction grating) may vary across the device surface. The pitch across different parts of the device surface may be varied so that the redirected beam is preferentially focused on desired locations of the sample, such as immediately below or in the vicinity of the electron beam.

The diffraction grating shown in FIGs. 22 and 23 is a blazed diffraction grating having triangular "teeth". Other types of diffraction gratings may be used as the redirecting element, and the relevant design parameters may be varied appropriately. For example, the diffraction grating may comprise trapezoidal teeth. In this case, the angle of each side of the trapezoidal "tooth" may be varied, as well as the length of the trapezoid which faces the sample.

The duty cycle of such a trapezoidal grating (i.e. the ratio of the tooth's width to the grating pitch) may be varied.

Other design parameters which may be varied include the width of the redirecting element (x1₎ and the separation of the redirecting element from the aperture 606 through which the electron beam passes (xo).

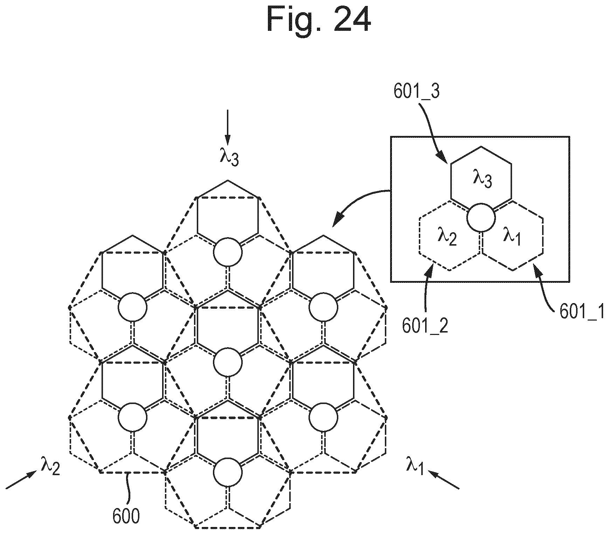

FIG. 24 shows an example arrangement of surface elements 600 each having redirecting elements 601_1, 601_2, 601_3 disposed thereon. Each of the surface elements 600 having redirecting elements 601_1, 601_2, 601_3 may correspond to a section of a detector surface, such as the detector array 240. The redirecting elements 601_1, 601_2, 601_3 may be arranged around an aperture which allows passage of a beam to the sample surface, such as aperture 266.

The redirecting elements may comprise any suitable element configured to direct light along a light path and towards the sample surface. For example, the redirecting elements may comprise diffraction gratings (such as the examples in FIGs. 23 and 24), reflective elements such as mirrors or micro-mirrors, and other suitable means.

The redirecting element may comprise a transparent conductive material. At least a portion of the redirecting element may comprise the transparent conductive material. Accordingly, the buildup of charge can be prevented. In an example, the redirecting elements may be at least partially constituted of a material selected from a listing comprising: polymers, metals, metal oxides, ceramics, carbon.

According to an aspect of the present invention, there is provided a charged particle system which can further improve homogeneous distribution of the light beam across the sample.

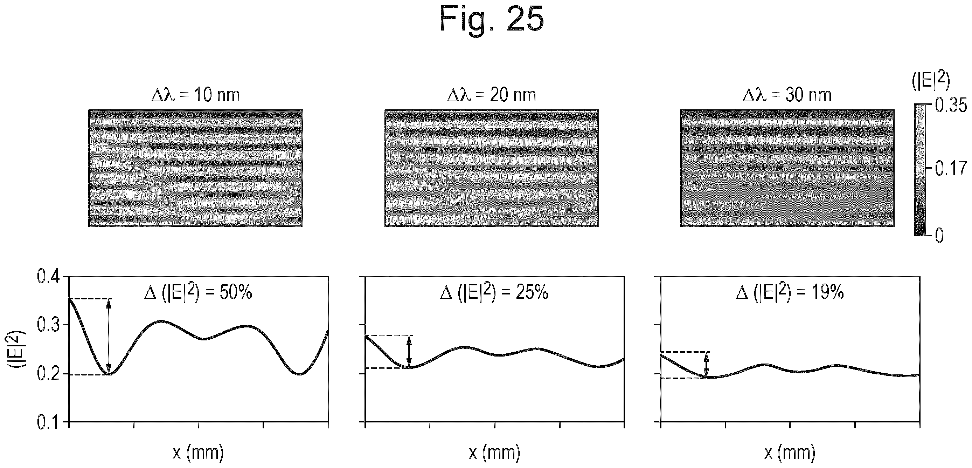

Using coherent light in a projection system may be disadvantageous, because use of coherent light may result in interference fringes in the optical field distribution near the device surface. This may lead to inhomogeneous illumination of the sample surface. For example, FIG. 25 shows the electric field distribution in the space between a detector surface and the sample for various degrees of light coherence. Use of partially coherent light may mitigate the optical intensity inhomogeneity and lead to an increase in efficiency of the ACC.

According to the present invention, the light sources may be configured to emit a partially coherent light beam. A partially coherent beam may have a central wavelength and a bandwidth. In a preferable embodiment, the bandwidth is determined by the bandwidth of the redirecting element, i.e. the bandwidth of wavelengths which the redirecting element can redirect efficiently. For example, when the redirecting element is a diffraction grating, the wavelength bandwidth is the bandwidth over which the grating diffracts light efficiently. Preferably, the light is diffracted with an absolute efficiency of over 60 %, and preferably, over 70%. The bandwidth is used to refer to the spectrum of wavelengths present in the light beam.

For example, FIG. 18 indicates that the diffraction grating diffracts wavelengths of approximately 350-600 nm with an efficiency of over 60%. Thus, this diffraction grating may be appropriate for a light beam having a central wavelength of 475 nm and a bandwidth of 250 nm. Wavelengths of 400-500 nm are diffracted with an efficiency of 70% and greater. In a preferable embodiment, the diffraction grating of FIG. 18 may be used as the redirecting element for a light beam having a central wavelength of 450 nm and a bandwidth of 100 nm.

In an embodiment, the bandwidth may be equal to or greater than 20 nm and equal to or less than 100 nm. For example, a light source having a central wavelength of 500 nm and a bandwidth of 50 nm includes wavelengths falling in the range of 450 nm to 550 nm.

In preferable embodiments of the invention, the bandwidth may be greater than 100 nm. As illustrated in FIG. 25, a greater bandwidth leads to increased homogeneity of the electric field distribution and increased efficiency of the ACC. Redirecting elements such as mirrors or micro-mirrors may be effective at redirecting a light beam having a relatively large bandwidth, such as 100 nm or greater. In an embodiment, redirecting elements such as mirrors or micro-mirrors may be used to redirect a light beam having a bandwidth of hundreds of nm (e.g. 200 nm, 300 nm, 400 nm or even greater).

Where reference is made to a redirecting element associated with a wavelength in relation to embodiments of the present invention, the redirecting element may be associated with a central wavelength of a partially coherent light beam.

Partially coherent light may be provided via any suitable means, such as a superluminescent diode, a spectrally filtered supercontinuum light source, short-pulse lasers.

In an embodiment the electron-optical apparatus 140 comprises a secondary electron-optical device comprising the detector array 240. In such an embodiment a beam separator typically is arranged to deflect the path of the signal electrons towards the secondary electron-optical device. The secondary electron-optical device subsequently directs the signal electrons towards the detector array 240 and focuses the signal electrons (e.g. secondary electrons) onto the detector array 240.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

Embodiments include the following numbered clauses:
Clause 1. A charged particle assessment system comprising:
   a sample holder configured to hold a sample having a surface;
   a charged particle-optical device configured to project a charged particle beam towards the sample, the charged particle-optical device being configured to deflect the charged particle beam over a part of the surface of the sample,
   the charged particle-optical device having a device surface, the device surface facing, in use, the surface of the sample;
   a projection assembly arranged to direct a plurality of light beams along respective light paths, wherein the plurality of light beams include light beams having different wavelengths; and
   wherein the device surface comprises a plurality of redirecting elements, each of the redirecting elements being associated with one of the respective wavelengths, wherein each of the redirecting elements is configured to direct light onto the sample.
Clause 2. The charged particle system of clause 1, wherein the light beams are emitted by associated light sources.
Clause 3. The charged particle system of clause 1 or clause 2, wherein the redirecting element is associated with one wavelength along one direction of the redirecting element surface and another wavelength along another direction of the redirecting element surface.
Clause 4. The charged particle system according to any of the preceding clauses, wherein the projection assembly is configured to direct two light beams, such that the two light beams cross at an angle of between 60 and 90 degrees.
Clause 5. The charged particle system according to any of the preceding clauses, wherein the projection assembly is configured to direct three light beams, such that the angle between a given beam and any of the adjacent beams is between 50 and 70 degrees.
Clause 6. The charged particle system according to any of the preceding clauses, wherein each of the light sources is configured to emit light having a wavelength of equal to or less than 900 nm.
Clause 7. The charged particle system according to any of the preceding clauses, wherein the light sources are configured to emit a partially coherent light beam.
Clause 8. The charged particle system according to clause 7, wherein the light sources are configured to emit light having a central wavelength and a bandwidth ranging from 20 to 100 nm.
Clause 9. The charged particle system according to clause 7, wherein the light sources are configured to emit light having a central wavelength and a bandwidth of 100 nm or greater
Clause 10. The charged particle system according to clause 8 or clause 9, wherein the redirecting elements are associated with the central wavelength of the light beams.
Clause 11. The charged particle system according to any of the preceding clauses, wherein at least one of the multiple light beams is emitted from a light guide.
Clause 12. The charged particle system according to any of the preceding clauses, wherein at least one light beams is directed between the sample surface and the device surface.
Clause 13. The charged particle system according to any of the preceding clauses, wherein the charged particle system further comprises a detector for detecting interaction products from interaction of the charged particle beam with the sample, wherein at least one of the redirecting elements is integrated into a detector surface constituting at least part of the device surface.
Clause 14. The charged particle system according to any of the preceding clauses, wherein at least one of the redirecting element constitutes a diffraction grating for the associated light beam.
Clause 15. The charged particle system according to any of the preceding clauses, wherein at least one redirecting elements comprises a mirror.
Clause 16. The charged particle system according to any of the preceding clauses, wherein at least one redirecting element comprises a micro-mirror.
Clause 17. The charged particle system according to any of the preceding clauses, wherein at least one redirecting element comprises a reflective feature.
Clause 18. A method of operating a charged particle system comprising:
   projecting a charged particle beam towards a sample using a charged particle-optical device, the charged particle-optical device being configured to deflect the charged particle beam over a part of the surface of the sample,
   the charged particle-optical device having a device surface, the device surface facing, in use, the surface of the sample ;
   directing a plurality of light beams along respective light paths, wherein the plurality of light beams includes light beams having respective wavelengths that are different from each other,
   wherein the device surface comprises a plurality of redirecting elements, each of the redirecting elements being associated with one of the respective wavelengths, wherein each of the redirecting elements is configured to direct light onto the sample.
Clause 19. A charged particle-optical element comprising a detector for detecting interaction products from interaction of a charged particle beam with a sample,
   the detector having a device surface configured to face, in use, a sample,
   wherein the device surface comprises a plurality of redirecting elements, each of the redirecting elements being associated with one of the respective wavelengths, wherein each of the redirecting elements is configured to direct light onto the sample.

List of reference numerals:
60 projection assembly
61 light source
62 light beam
63 optical system
64 cylindrical lens
70 gap
71 portion of surface
72 facing surface
73 topographical region
82 reflection
100 assessment apparatus
110 vacuum chamber (main chamber)
120 load lock chamber
124 gun aperture
125 beam limit aperture
130 EFEM
130a first loading port
130b second loading port
132a pole piece
132b control electrode
132c deflector
132d exciting coil
135 column aperture
140 electron-optical apparatus (electron beam apparatus, electron apparatus)
148 first multipole lens
150 controller
158 second multipole lens
201 source
202 source beam
204 electron-optical axis
207 sample holder
208 sample
209 actuatable stage
211, 212, 213 primary beams (sub-beams, beamlets)
220 source converter (micro-optical array)
223 pre-bending deflector array
224 aberration reduction array
230 electron-optical device (electron-optical column)
231 condenser lens array
240 detector array
241 objective lens array
242 beam shaper array
243 objective lens
250 control lens array
252 beam limiting aperture array
260 scan deflector array
261 plate
264 detector substrate
265 detector elements
266 beam apertures
267 logic layer
268 wiring layer
269 through-substrate vias
270 macro collimator
271 collimator array
272 Coulomb aperture array
273 intermediate focus plane
274 macro condenser lens
275 macro scan deflector
281-283 probe spots
291 photon converter array
292 fluorescent strip
293 openings
295 deflector array
296 magnetic deflector
297 electrostatic deflector
298 optical fiber
299 electron-optical device array
600 surface element
601, 601_1, 601_2, 601_3 redirecting element
602 device surface
606 aperture

## Claims

1. A charged particle assessment system comprising:
a sample holder configured to hold a sample having a surface;
a charged particle-optical device configured to project a charged particle beam towards the sample, the charged particle-optical device being configured to deflect the charged particle beam over a part of the surface of the sample,
the charged particle-optical device having a device surface, the device surface facing, in use, the surface of the sample;
a projection assembly arranged to direct a plurality of light beams along respective light paths, wherein the plurality of light beams include light beams having different wavelengths; and
wherein the device surface comprises a plurality of redirecting elements, each of the redirecting elements being associated with one of the respective wavelengths, wherein each of the redirecting elements is configured to direct light onto the sample.

2. The charged particle system of claim 1, wherein the light beams are emitted by associated light sources.

3. The charged particle system of claim 1 or claim 2, wherein the redirecting element is associated with one wavelength along one direction of the redirecting element surface and another wavelength along another direction of the redirecting element surface.

4. The charged particle system according to any of the preceding claims, wherein the projection assembly is configured to direct two light beams, such that the two light beams cross at an angle between 60 and 90 degrees.

5. The charged particle system according to any of the preceding claims, wherein the projection assembly is configured to direct three light beams, such that the angle between a given beam and any of the adjacent beams is between 50 and 70 degrees.

6. The charged particle system according to any of the preceding claims, wherein each of the light sources is configured to emit light having a wavelength of equal to or less than 900 nm.

7. The charged particle system according to any of the preceding claims, wherein the light sources are configured to emit a partially coherent light beam.

8. The charged particle system according to claim 7, wherein the light sources are configured to emit light having a central wavelength and a bandwidth ranging from 20 to 100 nm.

9. The charged particle system according to claim 8, wherein the redirecting elements are associated with the central wavelength of the light beams.

10. The charged particle system according to any of the preceding claims, wherein at least one of the multiple light beams is emitted from a light guide.

11. The charged particle system according to any of the preceding claims, wherein at least one of the light beams is directed between the sample surface and the device surface.

12. The charged particle system according to any of the preceding claims, wherein the charged particle system further comprises a detector for detecting interaction products from interaction of the charged particle beam with the sample, wherein at least one of the redirecting elements is integrated into a detector surface constituting at least part of the device surface.

13. The charged particle system according to any of the preceding claims, wherein at least one of the redirecting element constitutes a diffraction grating for the associated light beam.

14. The charged particle system according to any of the preceding claims, wherein at least one redirecting element comprises a reflective feature.

15. A charged particle-optical element comprising a detector for detecting interaction products from interaction of a charged particle beam with a sample,
the detector having a device surface configured to face, in use, a sample,
wherein the device surface comprises a plurality of redirecting elements, each of the redirecting elements being associated with one respective central wavelength, wherein each of the redirecting elements is configured to direct light onto the sample.
